# EUROPEAN PATENT APPLICATION

(11) **EP 4 325 293 A2**
(43) Date of publication of application: **21.02.2024**
(21) Application number: 23190766.8
(22) Date of filing: 10.08.2023
(51) Int. Cl.: G03F 7/11, G03F 7/038

(54) **COMPOSITION FOR FORMING ADHESIVE FILM, PATTERNING PROCESS, AND METHOD FOR FORMING ADHESIVE FILM**

(30) Priority: 17.08.2022 JP 2022130259
(71) Applicant: SHIN-ETSU CHEMICAL CO., LTD., Tokyo 1000005 (JP)
(72) Inventor: Tachibana, Seiichiro, Niigata (JP); Watanabe, Takeru, Niigata (JP); Kori, Daisuke, Niigata (JP); Sawamura, Takashi, Niigata (JP)
(74) Representative: Sonnenhauser, Thomas Martin

(57) **Abstract**

The present invention provides a composition for forming an adhesive film that provides an adhesive film that yields good pattern profiles and has high adhesion to a resist upper layer film to prevent collapse of fine patterns in a fine patterning process during semiconductor apparatus manufacturing processes, as well as a patterning process using the composition and a method for forming an adhesive film using the composition. As such, provided is a composition for forming an adhesive film directly under a resist upper layer film. The composition includes: (A) a polymer containing a repeating unit shown by the following general formula (1) and a repeating unit shown by the following general formula (2); and (B) an organic solvent.

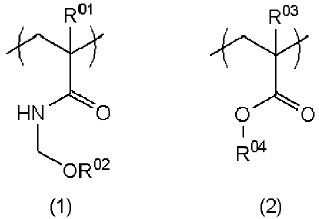

## Description

### TECHNICAL FIELD

The present invention relates to a composition for forming an adhesive film, a patterning process, and a method for forming an adhesive film.

### BACKGROUND ART

As LSIs become more highly integrated and faster, miniaturization of pattern dimensions is progressing rapidly. Along with such miniaturization, lithography techniques have enabled fine patterning by shortening wavelengths of light sources and selecting appropriate resist compositions accordingly. A main feature of the techniques is the use of positive photoresist compositions for monolayers. The monolayer positive photoresist composition provides a resist resin with a backbone that is resistant to dry etching with chlorine- or fluorine-based gas plasma and also provides a switching mechanism that allows exposed areas to dissolve, thereby dissolving the exposed areas to form a pattern and dry-etching a substrate to be processed, coated with a photoresist composition, using the residual resist pattern as an etching mask.

However, miniaturing the pattern, i.e., reducing the pattern width, without changing the film thickness of the photoresist film used will result in reduced resolution performance of the photoresist film and, in the case of a line-and-space pattern, result in collapse of the pattern during development of the photoresist film with a chemical solution due to an excessively increased aspect ratio of the line pattern. Accordingly, film thinning of the photoresist film has been performed along with the pattern miniaturization.

On the other hand, a substrate to be processed is generally processed by dry etching while using a photoresist film having a formed pattern as a mask. However, etching selectivity between the photoresist film and the substrate to be processed cannot be ensured due to the fact that photoresist films have been thinned. In other words, the photoresist film will be damaged during processing of the substrate to be processed and will thus collapse during processing of the substrate to be processed, which makes it impossible to accurately transfer the resist pattern to the substrate to be processed. Hence, with the miniaturization of patterns, higher dry etching resistance has been required for photoresist compositions. Meanwhile, resin employed in photoresist compositions is required to have low absorbance at exposure wavelengths. Accordingly, as the exposure light has shifted from i-line through KrF to ArF so as to have shorter wavelengths, the structure of resin has also shifted to a novolac resin, polyhydroxystyrene, and a resin with an aliphatic polycyclic backbone. This means that an etching rate increases under the above dry etching conditions. In other words, recent photoresist compositions with high resolution tend to have rather weak etching resistance.

Thus, the substrate to be processed needs to be dry-etched with a thinner, less etching resistant photoresist film, so that a need exists for a material and process for such processing.

One method to solve these problems is a multilayer resist method. This method proceeds as follows: a resist middle layer film with a different etching selectivity from a photoresist film (i.e., resist upper layer film) is interposed between the resist upper layer film and the substrate to be processed; a pattern is formed in the resist upper layer film; the pattern is then transferred to the resist middle layer film by dry etching while using the resist upper layer film pattern as a dry etching mask; and the pattern is further transferred to the substrate to be processed by dry etching while using the resist middle layer film as a dry etching mask.

One example of the multilayer resist methods is a three-layer resist method, which can be performed with typical resist compositions employed in monolayer resist methods. In this three-layer resist method, for example, an organic film of a novolac resin or the like is formed as a resist underlayer film on the substrate to be processed, and a silicon-containing film is formed thereon as a silicon-containing resist middle layer film, followed by forming thereon an ordinary organic photoresist film as a resist upper layer film. Since the organic resist upper layer film has a good etching selectivity with respect to the silicon-containing resist middle layer film for dry etching with fluorine-based gas plasma, dry etching with fluorine-based gas plasma can be used to transfer the resist upper layer film pattern to the silicon-containing resist middle layer film. Further, since the silicon-containing resist middle layer film has a good etching selectivity with respect to the resist underlayer film for etching with oxygen gas or hydrogen gas, the silicon-containing resist middle layer film pattern is transferred to the resist underlayer film by etching with oxygen gas or hydrogen gas. Even with the use of a photoresist composition that has difficulty in forming a pattern with a sufficient film thickness for directly processing the substrate to be processed or with the use of a photoresist composition that lacks sufficient dry etching resistance for processing the substrate, this method allows the pattern to be transferred to the silicon-containing film (silicon-containing resist middle layer film) and thus can obtain the pattern of the organic film (resist underlayer film) of a novolac resin or the like, which has sufficient dry etching resistance for processing.

As a promising alternative to the combined use of ArF immersion lithography and a multiple exposure process, a recent focus has been on vacuum ultraviolet (EUV) lithography with a wavelength of 13.5 nm. The use of this technology has made it possible to form a fine pattern with a half pitch of 25 nm or less in one exposure.

Meanwhile, EUV lithography places strong demands on the resist materials to have higher sensitivity in order to compensate for insufficient output of light sources. However, an increase in shot noise accompanying the increased sensitivity leads to an increase in edge roughness (LER and LWR) of line patterns. As such, ensuring both increased sensitivity and reduced edge roughness is considered as one of the most important challenges in the EUV lithography.

One of recently considered attempts to increase the sensitivity of the resists and reduce the effect of shot noise is to use metal materials as resist materials. A compound that contains a metal element such as barium, titanium, hafnium, zirconium, and tin has a higher absorbance of EUV light as compared to metal-free organic materials, so that it holds promise for improving the photosensitivity of the resists and inhibiting the effect of shot noise. Additionally, a metal-containing resist pattern holds promise for enabling a high-selectivity etching process when combined with an underlayer film made of a non-metal material.

For example, resist materials using metal salts, organometallic complexes, and metal clusters have been considered (Patent Documents 1 to 5 and Non Patent Document 1). However, the resolution of these metal-containing resists have not yet reached a level required for practical use, and further improvement of resolution is required.

Additionally, the advent of techniques such as ArF immersion lithography and EUV lithography is making it possible to form finer patterns. On the other hand, however, ultrafine patterns have such small contact areas that the patterns quite easily collapse. Thus, inhibiting such pattern collapse is an enormous challenge. Some publications report materials that improves adhesion to a resist upper layer film by use of a resist underlayer film containing a polar functional group such as lactone and urea structures in order to inhibit pattern collapse (Patent Documents 6 and 7). However, in current situations where finer patterning is required, these materials are not effective enough to inhibit pattern collapse.

Recently, it is recognized that interaction between a resist upper layer film and a resist underlayer film at their interface in a fine pattern also affects the sensitivity of the resist, pattern profile (rectangularity and residues in space portions), and the like. In view of these considerations as well, improvement to the performance of the resist underlayer film is required (Non Patent Document 2). From the above, the leading-edge microfabrication requires an adhesive film that does not generate resides in pattern space portions (portions where the resist upper layer film is removed by development), enables patterning with high rectangularity, and also inhibits pattern collapse.

### CITATION LIST

### PATENT LITERATURE

Patent Document 1: JP 5708521 B
Patent Document 2: JP 5708522 B
Patent Document 3: JP 2021-033090 A
Patent Document 4: JP 2021-039171 A
Patent Document 5: US 9310684 B
Patent Document 6: WO 2003/017002 A1
Patent Document 7: WO 2018/143359 A1

### NON PATENT LITERATURE

Non Patent Document 1: Proc. SPIE Vol. 7969, 796915 (2011)
Non Patent Document 2: Proc. SPIE Vol. 7273, 72731J (2009)

### SUMMARY OF INVENTION

### TECHNICAL PROBLEM

The present invention has been made in view of the above circumstances. An object of the present invention is to provide a composition for forming an adhesive film that provides an adhesive film that yields good pattern profiles and has high adhesion to a resist upper layer film to prevent collapse of fine patterns in a fine patterning process during semiconductor apparatus manufacturing processes, as well as a patterning process using the composition and a method for forming an adhesive film using the composition.

### SOLUTION TO PROBLEM

To achieve the object, the present invention provides a composition for forming an adhesive film directly under a resist upper layer film, the composition comprising:
(A) a polymer containing a repeating unit shown by the following general formula (1) and a repeating unit shown by the following general formula (2); and
(B) an organic solvent, 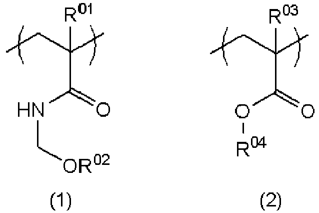 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 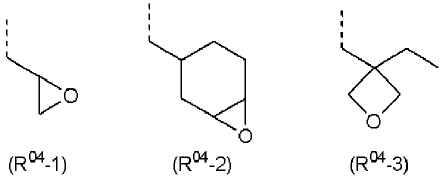 wherein dashed lines denote bonding hands.

Such a composition for forming an adhesive film can form an adhesive film that has high adhesion to a resist upper layer film so as to have the effect of preventing collapse of fine patterns and yields good pattern profiles.

In the present invention, the polymer (A) preferably further contains the following general formula (3), 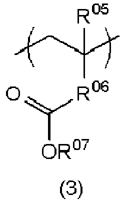 wherein R⁰⁵ is a hydrogen atom or a methyl group, R⁰⁶ is a single bond or a divalent linking group having 2 to 10 carbon atoms and containing an ester group, and R⁰⁷ is a saturated or unsaturated tertiary alkyl group having 4 to 20 carbon atoms.

Such a structure of the adhesive film provides higher adhesion to a resist upper layer film, which is effective in preventing collapse of fine patterns.

The inventive composition for forming an adhesive film preferably provides an adhesive film with a film thickness of 15 nm or less directly under the resist upper layer film.

The inventive composition for forming an adhesive film can reduce the film thickness distribution in the wafer plane even for thin films of 15 nm or less.

In the present invention, the polymer (A) preferably has a weight average molecular weight of 6,000 to 50,000.

In the present invention, the polymer (A) preferably has a dispersity of 3.0 or less, the dispersity being expressed as weight average molecular weight/number average molecular weight.

Setting the weight average molecular weight and dispersity of the polymer contained in the composition for forming an adhesive film within such ranges provides excellent film forming properties, and can also reduce the generation of sublimates during thermal curing, thereby preventing contamination of the apparatus.

In the present invention, in the polymer (A), a content of the repeating unit shown by the general formula (1) is preferably 20 mol% or more and 80 mol% or less relative to whole repeating units, and a content of the repeating unit shown by the general formula (2) is preferably 20 mol% or more and 80 mol% or less relative to the whole repeating units.

Setting such a composition ratio for the polymer contained in the composition for forming an adhesive film provides particularly high adhesion to a resist upper layer film and is effective in preventing collapse of fine patterns. Such a composition ratio also ensures good crosslinking reactivity during thermal film formation on the wafer, making it possible to prevent intermixing with the resist upper layer film and form a good pattern.

The inventive composition preferably further comprises at least one of (C) a thermal acid generator, (D) a photo acid generator, (E) a crosslinking agent, and (F) a surfactant.

Depending on whether and which of these various additives are used, fine-tuning of the performance in various aspects, including film forming properties, reduction of sublimates, and resist patterning, is possible to meet customer demands, offering practical advantages.

In the present invention, the resist upper layer film is preferably formed using a composition for forming a resist upper layer film containing at least a metal atom-containing compound and an organic solvent.

In such cases, the metal atom-containing compound preferably includes at least one element selected from titanium, cobalt, copper, zinc, zirconium, lead, indium, tin, antimony and hafnium.

Combining the adhesive film formed from the inventive composition with such a resist upper layer film can inhibit the collapse of fine patterns and provide good pattern profiles. This approach can also prevent metal compounds from contaminating the substrate to be processed.

In addition, the present invention provides a patterning process for forming a pattern in a substrate to be processed, comprising the steps of:
(I-1) applying the aforementioned composition for forming an adhesive film on the substrate to be processed and then performing a heat treatment to form an adhesive film;
(I-2) forming a resist upper layer film on the adhesive film by using a composition for forming a resist upper layer film;
(I-3) subjecting the resist upper layer film to pattern exposure and then to development with a developer to form a circuit pattern in the resist upper layer film; and
(I-4) transferring the pattern to the adhesive film and the substrate to be processed by dry etching while using the resist upper layer film having the formed circuit pattern as a mask.

In addition, the invention provides a patterning process for forming a pattern in a substrate to be processed, comprising the steps of:
(II-1) forming a resist underlayer film on the substrate to be processed;
(II-2) forming a silicon-containing resist middle layer film on the resist underlayer film;
(II-3) applying the aforementioned composition for forming an adhesive film on the silicon-containing resist middle layer film and then performing a heat treatment to form an adhesive film;
(II-4) forming a resist upper layer film on the adhesive film by using a composition for forming a resist upper layer film;
(II-5) subjecting the resist upper layer film to pattern exposure and then to development with a developer to form a circuit pattern in the resist upper layer film;
(II-6) transferring the pattern to the adhesive film and the silicon-containing resist middle layer film by dry etching while using the resist upper layer film having the formed circuit pattern as a mask;
(II-7) transferring the pattern to the resist underlayer film by dry etching while using the silicon-containing resist middle layer film having the transferred pattern as a mask; and
(II-8) forming the pattern in the substrate to be processed by processing the substrate to be processed while using the resist underlayer film having the transferred pattern as a mask.

In addition, the present invention provides a patterning process for forming a pattern in a substrate to be processed, comprising the steps of:
(III-1) forming a resist underlayer film on the substrate to be processed;
(III-2) forming an inorganic hard mask middle layer film selected from a silicon oxide film, a silicon nitride film, and a silicon oxynitride film on the resist underlayer film;
(III-3) applying the aforementioned composition for forming an adhesive film on the inorganic hard mask middle layer film and then performing a heat treatment to form an adhesive film;
(III-4) forming a resist upper layer film on the adhesive film by using a composition for forming a resist upper layer film;
(III-5) subjecting the resist upper layer film to pattern exposure and then to development with a developer to form a circuit pattern in the resist upper layer film;
(III-6) transferring the pattern to the adhesive film and the inorganic hard mask middle layer film by dry etching while using the resist upper layer film having the formed circuit pattern as a mask;
(III-7) transferring the pattern to the resist underlayer film by dry etching while using the inorganic hard mask middle layer film with the transferred pattern as a mask; and
(III-8) forming the pattern in the substrate to be processed by processing the substrate to be processed while using the resist underlayer film having the transferred pattern as a mask.

Thus, the inventive composition for forming an adhesive film can be suitably used for various patterning processes, such as a two-layer resist process and a four-layer resist process in which the above adhesive film is formed on a silicon-containing middle layer film (silicon-containing resist middle layer film or inorganic hard mask middle layer film), and the above patterning processes can effectively inhibit the collapse of patterns by virtue of the inventive adhesive film and thus are suitable for photolithography of resist upper layer films.

The inorganic hard mask middle layer film is preferably formed by a CVD method or an ALD method.

In the present invention, photolithography at a wavelength of 10 nm or more to 300 nm or less, a direct drawing by electron beam, a nanoimprinting, or a combination thereof is preferably employed as a method for forming the circuit pattern in the resist upper layer film.

In the present invention, alkaline development or development with an organic solvent is preferably employed as a development method.

In the present invention, the patterning processes as described above can be used for good and efficient patterning.

In the present invention, the substrate to be processed is preferably a semiconductor apparatus substrate or the semiconductor apparatus substrate coated with any of a metal film, a metal carbide film, a metal oxide film, a metal nitride film, a metal oxycarbide film, and a metal oxynitride film.

As the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is preferably used.

The inventive patterning processes can process the above-described substrate to be processed in the above manner to form a pattern thereon.

In addition, the present invention provides a method for forming an adhesive film employed in a semiconductor apparatus manufacturing process, the method comprising:
spin-coating a substrate to be processed with the aforementioned composition for forming an adhesive film; and
heating the substrate coated with the composition for forming an adhesive film at a temperature of 100°C or higher and 300°C or lower for 10 to 600 seconds to form an adhesive film.

In addition, the present invention provides a method for forming an adhesive film employed in a semiconductor apparatus manufacturing process, the method comprising:
spin-coating a substrate to be processed with the aforementioned composition for forming an adhesive film; and
heating the substrate coated with the composition for forming an adhesive film in an atmosphere having an oxygen concentration of 0.1% or more and 21% or less to form an adhesive film.

These methods can facilitate the crosslinking reaction during the adhesive film formation and further prevent mixing with the resist upper layer film. In addition, adjusting the heat treatment temperature, time, or oxygen concentration within the above ranges can adjust the resist pattern collapse inhibition effect of the adhesive film and the pattern profiles.

In addition, the present invention provides a method for forming an adhesive film employed in a semiconductor apparatus manufacturing process, the method comprising:
spin-coating a substrate to be processed with the aforementioned composition for forming an adhesive film; and
heating the substrate coated with the composition for forming an adhesive film in an atmosphere having an oxygen concentration of less than 0.1% to form an adhesive film.

This method is useful as it can facilitate the crosslinking reaction during the adhesive film formation and prevent intermixing with the upper layer film without causing any degradation of the substrate to be processed even when the substrate to be processed contains any material that is heat labile under an oxygen atmosphere.

### ADVANTAGEOUS EFFECTS OF INVENTION

As described above, the present invention provides a composition for forming an adhesive film that has high adhesion to a resist upper layer film to have the effect of inhibiting collapse of fine patterns. Since this composition for forming an adhesive film has high adhesion to have the effect of inhibiting collapse of fine patterns and provides a highly rectangular pattern profile of the resist upper layer film, the composition is extremely useful in multilayer resist processes, such as a four-layer resist process in which the adhesive film is formed on a silicon-containing middle layer film or an inorganic hard mask middle layer film. Additionally, the inventive method for forming an adhesive film can form an adhesive film that cures sufficiently on a substrate to be processed and has high adhesion to a resist upper layer film. Additionally, the inventive patterning process allows a fine pattern to be formed on a substrate to be processed with high precision in a multilayer resist process.

### BRIEF DESCRIPTION OF DRAWINGS

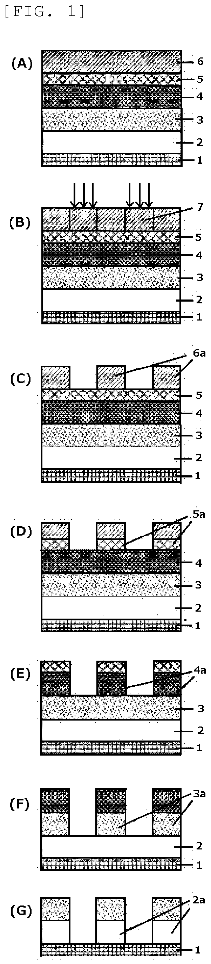

FIG. 1 illustrates an example of the inventive patterning process in a four-layer resist process.

### DESCRIPTION OF EMBODIMENTS

When an element is herein referred to as being "directly under" another element, it is directly in contact with the other element with no intervening elements. In contrast, when an element is referred to as being "under" another element, there may be an intervening element(s) therebetween. Similarly, when an element is referred to as being "directly on" another element, it is directly in contact with the other element with no intervening elements, and when an element is referred to as being "on" another element, there may be an intervening element(s) therebetween.

As described above, a need has existed for development of a composition for forming an adhesive film that provides an adhesive film that yields good pattern profiles and has high adhesion to a resist upper layer film to prevent collapse of fine patterns in a fine patterning process during semiconductor apparatus manufacturing processes, as well as a patterning process using the composition and a method for forming an adhesive film using the composition.

The present inventors have earnestly studied to achieve the above object and consequently found that the object can be achieved with a composition for forming an adhesive film that contains a polymer with a specific structure, a patterning process using this composition for forming an adhesive film, and a method for forming an adhesive film using this composition for forming an adhesive film. This finding has led to the completion of the present invention.

That is, the present invention is a composition for forming an adhesive film directly under a resist upper layer film, the composition comprising:
(A) a polymer containing a repeating unit shown by the following general formula (1) and a repeating unit shown by the following general formula (2); and
(B) an organic solvent, 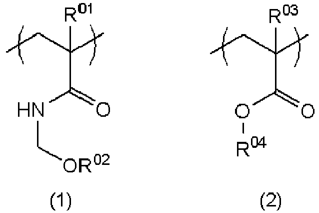 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 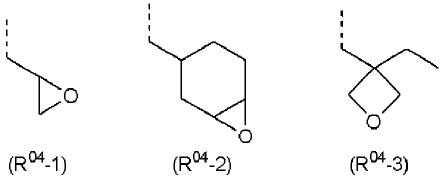 wherein dashed lines denote bonding hands.

Hereinafter, the present invention will be described in detail, but the present invention is not limited to the following description.

### Composition for Forming an Adhesive Film

The inventive composition for forming an adhesive film directly under a resist upper layer film includes: (A) a polymer containing a repeating unit shown by the following general formula (1) and a repeating unit shown by the following general formula (2); and (B) an organic solvent, 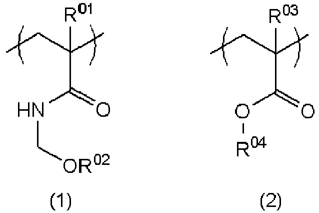 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 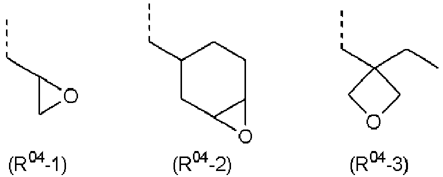 wherein dashed lines denote bonding hands.

In the inventive composition for forming an adhesive film, the polymer (A) can be of a single kind or a mixture of two or more kinds. Also, the above composition for forming an adhesive film may contain other components in addition to the components (A) and (B). These components are described below.

### Polymer (A)

The polymer (A) contained in the inventive composition for forming an adhesive film contains a repeating unit shown by the following general formula (1) and a repeating unit shown by the following general formula (2), 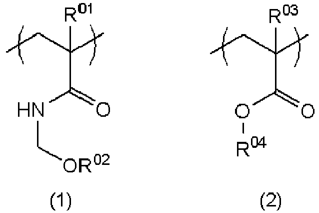 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 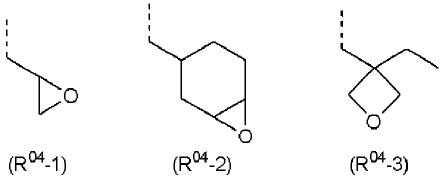 wherein dashed lines denote bonding hands.

Specific examples of R⁰² in the above general formula (1) include methyl, ethyl, n-propyl, isopropyl, n-butyl, sec-butyl, tert-butyl, n-pentyl, neopentyl, n-hexyl, n-heptyl, n-octyl, n-nonyl, n-decyl groups, and organic groups obtained by substituting hydrogen atoms constituting these alkyl groups with hydroxyl groups.

Specific preferred examples of the repeating unit shown by the above general formula (1) include the following structures, where R⁰¹ is the same as above.

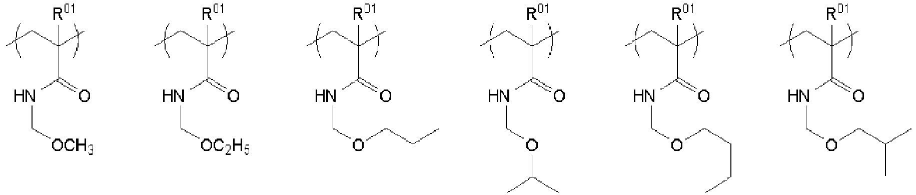

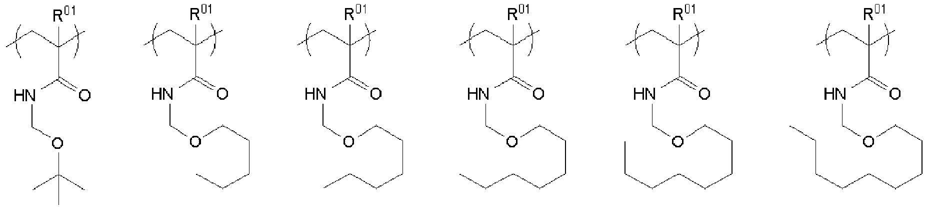

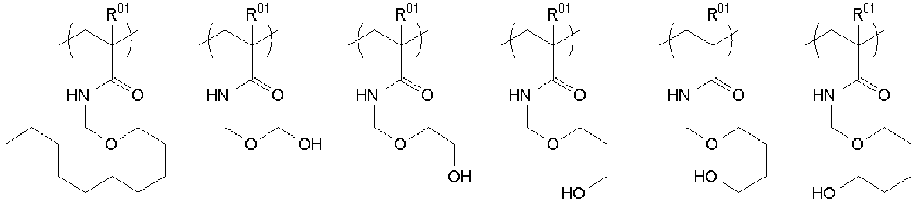

The repeating unit shown by the above general formula (1) has an adequate polarity and interacts with resist upper layer films, in particular those containing polar groups and for use in ArF and EUV lithography and electron beam direct drawing. This provides high adhesion to resist patterns, providing effectiveness in preventing collapse of fine resist patterns. Further, the curing reaction proceeds more effectively, which may be due to reaction between the cation generated from the above general formula (1) and the epoxy or oxetane structure of the above general formula (2) during thermal film formation, so that a very dense adhesive film can be formed, which can prevent intermixing of the adhesive film and the resist upper layer film. This in turn can prevent generation of residues in pattern space portions, yielding a pattern with high rectangularity.

Specific preferred examples of the repeating unit shown by the above general formula (2) include the following structures, where R⁰³ is the same as above.

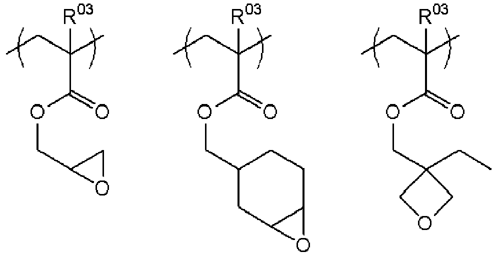

The repeating unit shown by the above general formula (2) functions as a crosslinking unit, and the epoxy or oxetane structure undergoes a ring-opening reaction during thermal film formation, causing the film to cure. As described above, combining the above general formula (1) in the polymer is effective in curing the film and thus enables formation of a dense film. In addition, hydroxyl groups generated by this ring-opening reaction also contribute to improving the adhesion to the resist upper layer film.

Preferably, the polymer (A) further includes a repeating unit shown by the following general formula (3), 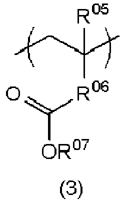 wherein R⁰⁵ is a hydrogen atom or a methyl group, R⁰⁶ is a single bond or a divalent linking group having 2 to 10 carbon atoms and containing an ester group, and R⁰⁷ is a saturated or unsaturated tertiary alkyl group having 4 to 20 carbon atoms.

In the above general formula (3), R⁰⁶ is a single bond or a divalent linking group having 2 to 10 carbon atoms and containing an ester group. Specific examples of R⁰⁶ include a single bond, -CO₂CH₂-, -CO₂CH₂CH₂-, - CO₂CH₂CH₂CH₂-, -CO₂CH(CH₃)-, -CO₂CH₂CH₂CH₂CH₂-, - CO₂CH₂CH₂CH₂CH₂CH₂-, -CO₂CH₂CH₂CH₂CH₂CH₂CH₂CH₂CH₂-, - CO₂CH₂CH₂O-, -CO₂CH₂CH₂OCH₂CH₂O-, and - CO₂CH₂CH₂OCH₂CH₂OCH₂CH₂O-. Among these, -CO₂CH₂-, - CO₂CH₂CH₂-, -CO₂CH₂CH₂CH₂-, -CO₂CH₂CH₂CH₂CH₂-, and - C0₂CH₂CH₂CH₂CH₂CH₂- are particularly preferable.

Specific examples of R⁰⁷ in the repeating unit shown by the above general formula (3) include, but not limited to, the following structures, where dashed lines denote bonding hands.

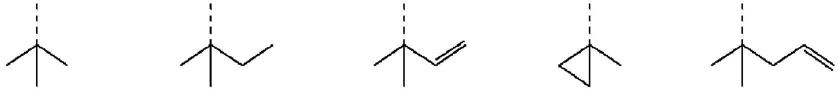

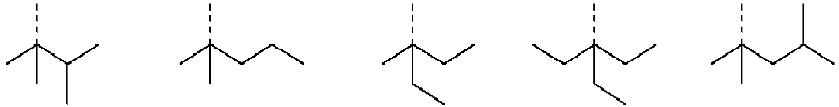

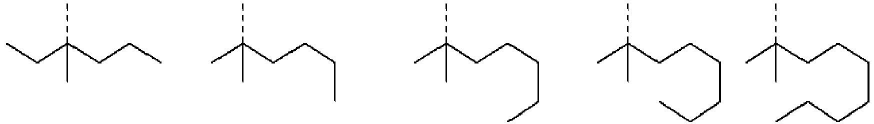

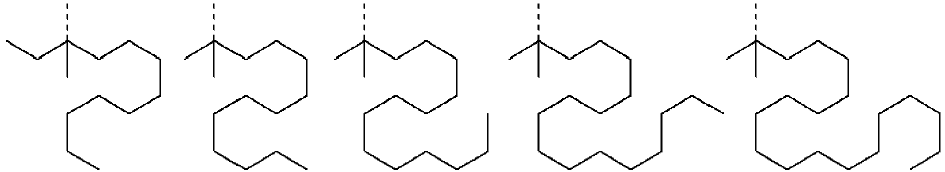

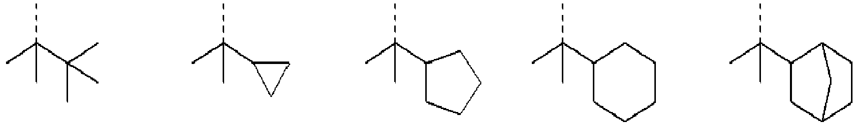

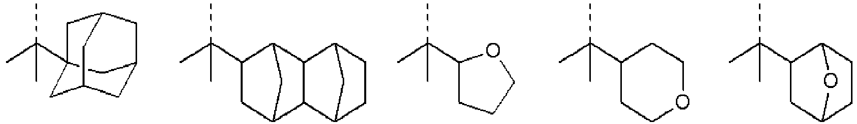

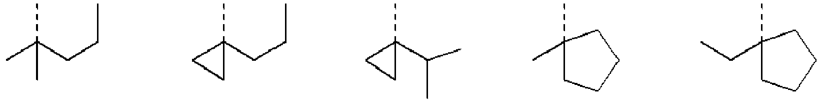

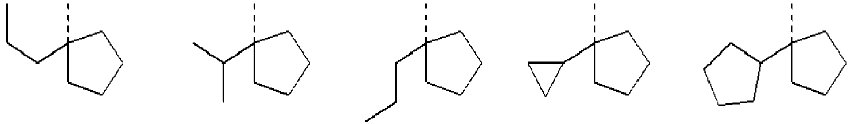

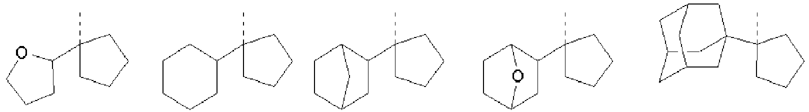

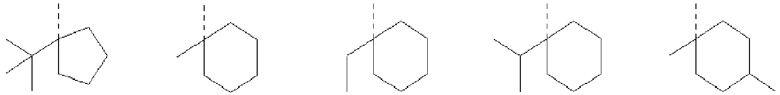

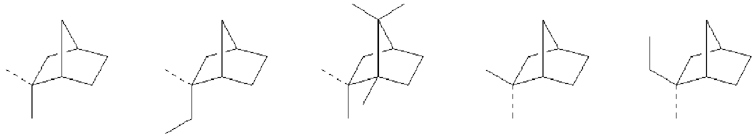

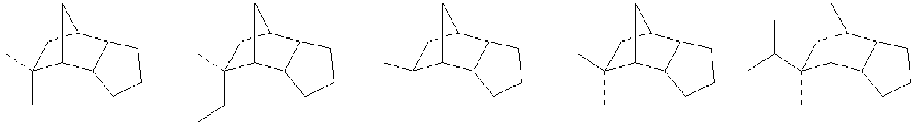

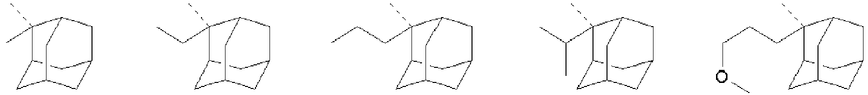

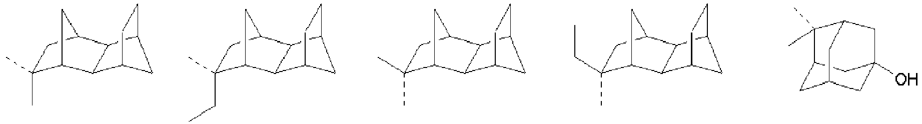

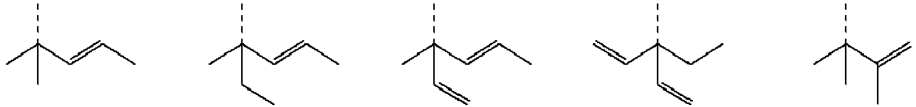

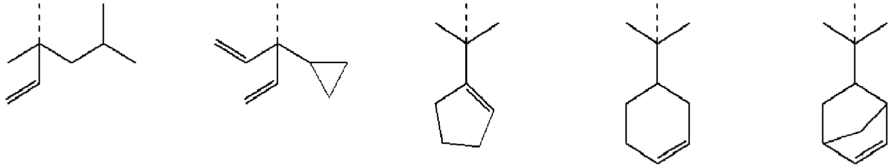

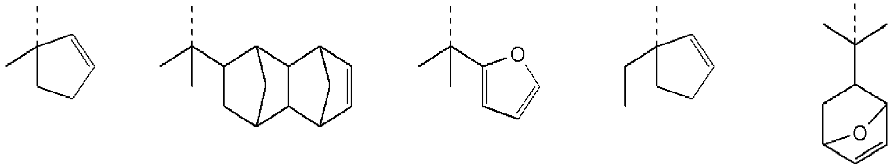

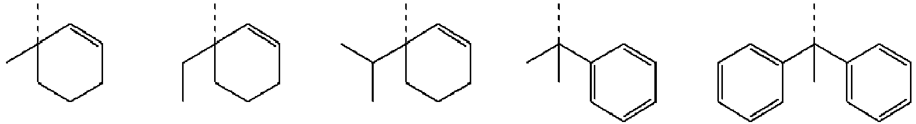

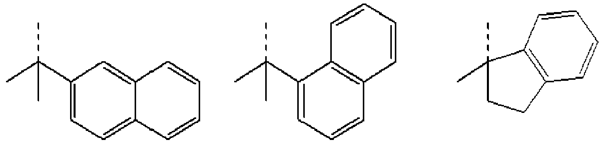

When forming an adhesive film from a polymer containing the repeating unit shown by the above general formula (3), an elimination and decomposition reaction of the tertiary alkyl group R⁰⁷ proceeds under influence of heat and/or an acid generated from an acid generator (described below), thereby generating a carboxylic acid. The polarity of the carboxylic acid improves the adhesion to the resist pattern, improves the rectangularity of the pattern, and prevents the generation of residues in the pattern space portions.

Also, the generated carboxylic acid may undergo a ring-opening addition reaction with the repeating unit shown by the above general formula (2) to form a hydroxyester crosslinking structure. A typical example of the reaction is shown below. In the schema below, a formula (4) represents the carboxylic acid formed by the elimination of R⁰⁷ in the repeating unit (3), and a formula (5) represents a compound with the hydroxyester crosslinking structure formed by the ring-opening addition reaction with a formula (2"), which is an example of the above general formula (2). The portion surrounded by the dotted line is the hydroxyester crosslinking structure formed by the reaction. 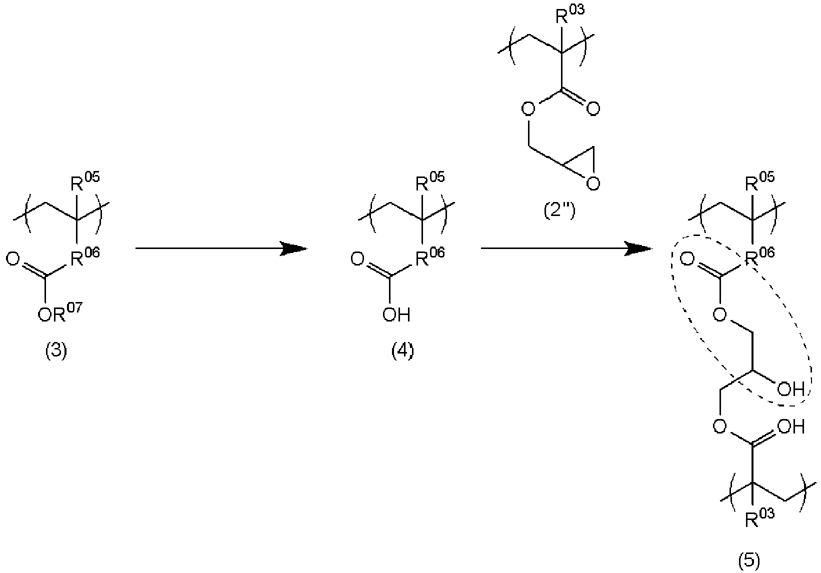 wherein R⁰³, R⁰⁵, R⁰⁶, R⁰⁷ are the same as above.

The formation of this hydroxyester crosslinking structure is a crosslinking reaction, which facilitates the curing of the adhesive film. Sufficient curing results in formation of a dense film and prevents intermixing of the adhesive film and the resist upper layer film, which in turn can prevent the generation of residues in the pattern space portions and yield a pattern with high rectangularity.

In addition, the above hydroxyester crosslinking structure is a polar group and interacts with the resist pattern, so that the presence of the repeating unit (3) also contributes to preventing the collapse of the resist pattern.

Only a single kind or two or more kinds of the repeating unit shown by the above general formula (3) may be contained in the polymer (A).

The inventive composition for forming an adhesive film can provide an adhesive film with a film thickness of 15 nm or less directly under the resist upper layer film.

As resist upper layer films become thinner along with miniaturization and designs that will lead to reduced dry etching resistance must be adopted due to resolution considerations, the adhesive film directly under the resist is required to be as thin as possible in order to reduce a load on the resist pattern during the etching process. Accordingly, the thickness of the adhesive film used in the present invention is preferably 15 nm or less, and particularly preferably 10 nm or less. The inventive composition for forming an adhesive film can reduce the film thickness distribution in the wafer plane by incorporating the design described below, even for thin films of 15 nm or less.

A spin coating method is preferably used to form an adhesive film with the thickness of 15 nm or less from the inventive composition for forming an adhesive film. The film can be formed by appropriately setting the concentration of the above polymer (A) contained in the composition for forming an adhesive film and/or the number of revolutions during spin coating.

The above polymer (A) preferably has a weight average molecular weight of 6,000 to 50,000. Also, a dispersity of the polymer (A), which is expressed as weight average molecular weight/number average molecular weight, is preferably 3.0 or less.

As used herein, the "weight average molecular weight" is a value measured by gel permeation chromatography (GPC) using tetrahydrofuran as a solvent and polystyrene as a reference substance. With such ranges of the weight average molecular weight and the dispersity of the polymer (A) contained in the composition for forming an adhesive film, excellent film forming properties are ensured for the spin coating, and also contamination of the apparatus can be prevented because generation of sublimates is reduced during the thermal curing. In particular, in the case of forming a thin film of 15 nm or less, presence of a volatile, low molecular weight component in the composition tends to vary the film thickness distribution in the wafer plane. However, setting the molecular weight and dispersity of the polymer used as described above and thereby controlling the amount of low molecular weight components in the composition can minimize the film thickness distribution in the wafer plane. Accordingly, the polymer (A) used in the inventive composition for forming an adhesive film preferably has a weight average molecular weight of 6,000 to 50,000, particularly preferably 8,000 to 40,000, and preferably has a dispersity of 3.0 or less.

In the polymer (A), a content of the repeating unit shown by the above general formula (1) is preferably 20 mol% or more and 80 mol% or less relative to whole repeating units, and a content of the repeating unit shown by the general formula (2) is preferably 20 mol% or more and 80 mol% or less relative to the whole repeating units.

Such a content ratio of the above general formulae (1) and (2) allows the polarity of the polymer (A) to be modified, providing good adhesion to the resist pattern. In addition, as the curing reaction, which is caused by reaction between cations generated from the above general formula (1) and the epoxy or oxetane structure of the above general formula (2) during the thermal film formation, proceeds effectively, a dense adhesive film can be formed, preventing intermixing of the adhesive film and the resist upper layer film. This in turn can prevent the generation of residues in pattern space portions and yield a pattern with high rectangularity. Accordingly, in the polymer (A), the content of the repeating unit shown by the above general formula (1) is preferably 20 mol% or more and 80 mol% or less, particularly preferably 30 mol% or more and 70 mol% or less, relative to whole repeating units, and the content of the repeating unit shown by the above general formula (2) is preferably 20 mol% or more and 80 mol% or less, particularly preferably 30 mol% or more and 70 mol% or less, relative to the whole repeating units.

An example method for synthesizing the polymer (A) is to mix monomers having a polymerizable unsaturated bond corresponding to each repeating unit and add a radical polymerization initiator in a solvent to perform thermal polymerization. Polymerization conditions can be selected in various ways depending on the monomers used, target molecular weight, etc. and are not particularly limited. Specific examples of the solvent used during the polymerization include toluene, benzene, tetrahydrofuran, diethyl ether, dioxane, 2-butanone, methyl isobutyl ketone, propylene glycol monomethyl ether acetate, cyclohexanone, γ-butyrolactone, ethyl acetate, butyl acetate, diacetone alcohol, etc. Examples of the radical polymerization initiator include 2,2'-azobisisobutyronitrile (AIBN), 2,2'-azobis(2,4-dimethylvaleronitrile), dimethyl 2,2-azobis(2-methylpropionate), benzoyl peroxide, lauroyl peroxide, etc. Thiols such as octanethiol and 2-mercaptoethanol may be added as a chain transfer agent during the polymerization. The polymerization reaction is preferably performed by heating to a range of 40°C to the boiling point of the reaction solvent. The reaction time is preferably 0.5 to 100 hours, more preferably 1 to 48 hours.

For example, the polymer containing the repeating units shown by the above general formulae (1), (2), and (3) can be synthesized by performing the polymerization as described above using compounds with polymerizable double bonds, as represented by the following general formulate (1'), (2'), and (3'), as monomers, 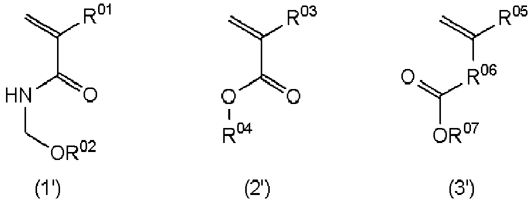 wherein R⁰¹-R⁰⁷ are the same as above.

For the polymerization, all raw materials may be mixed and then heated; alternatively, some of the raw materials may be heated in advance and then the remaining raw materials may be added thereto individually or in a mixed state, all at once or gradually. For example, a polymerization method of heating a polymerization solvent alone and then gradually and separately adding thereto a monomer solution and a polymerization initiator solution is preferred because such a method can provide a relatively homogeneous polymer and also prevent abnormal reactions such as runaway reactions.

The thus obtained polymer solution may be directly blended with the composition for forming an adhesive film; alternatively, the polymer may be purified by any usual method such as crystallization, liquid separation, filtration, or concentration to remove residual monomers, residual solvent, reaction byproducts, and other impurities. Preferred methods for purifying the polymer (A) include a crystallization method, in which a poor solvent such as water, a water-containing alcohol, or a saturated hydrocarbon is added into the polymer solution to collect the precipitation by filtration, and a liquid separation method, in which a poor solvent layer is separated and removed. Of these methods, the liquid separation method is particularly preferred. Purifying the polymer by the liquid separation method can efficiently remove low molecular weight components in the polymer solution and thus reduce the generation of sublimates during forming an adhesive film from the composition for forming an adhesive film containing this polymer, which, as a result, can prevent contamination of the film forming apparatus.

### (B) Organic Solvent

The composition for forming an adhesive film used in the present invention contains (b) an organic solvent. The organic solvent may be any organic solvent that can dissolve the polymer (A). In the case of adding the additive(s) described below ((C) thermal acid generator, (D) photo acid generator, (E) crosslinking agent, and (F) surfactant), preferred organic solvents are those that can also dissolve these additives. Specific examples, as disclosed in paragraphs [0144]-[0145] of JP 2008-111103 A, include: ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones such as γ-butyrolactone. A single one of these solvents or a mixture of two or more of these may be preferably used.

The amount of organic solvent added is preferably 5,000 parts or more, more preferably 8,000 parts or more, relative to 100 parts of the polymer (A).

### (C) Thermal Acid Generator

It is preferred to add (C) a thermal acid generator to the inventive composition for forming an adhesive film in order to facilitate thermal crosslinking reactions.

Examples of the thermal acid generator (C) that can be used for the inventive composition for forming an adhesive film include the following general formula (6), 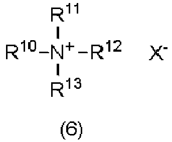 wherein X⁻ represents a non-nucleophilic counter ion, and R¹⁰, R¹¹, R¹², and R¹³ each represent a hydrogen atom or a linear, branched, or cyclic alkyl, alkenyl, oxoalkyl, or oxoalkenyl group having 1 to 12 carbon atoms, an aryl group having 6 to 20 carbon atoms, or an aralkyl or aryl oxoalkyl group having 7 to 12 carbon atoms, where hydrogen atoms of these groups may all or in part be substituted with alkoxy groups, etc. R¹⁰ and R¹¹, and R¹⁰, R¹¹ and R¹² may form a ring, and when a ring is formed, R¹⁰ and R¹¹, and R¹⁰, R¹¹ and R¹² represent an alkylene group having 3 to 10 carbon atoms or a heteroaromatic ring containing in it the nitrogen atom in the formula.

Above R¹⁰, R¹¹, R¹², and R¹³ may be identical to or different from each other. Specific examples of the alkyl group include methyl, ethyl, propyl, isopropyl, n-butyl, sec-butyl, tert-butyl, pentyl, hexyl, heptyl, octyl, cyclopentyl, cyclohexyl, cycloheptyl, cyclopropylmethyl, 4-methylcyclohexyl, cyclohexylmethyl, norbornyl, and admantyl groups.

Examples of the alkenyl group include vinyl, allyl, propenyl, butenyl, hexenyl, and cyclohexenyl groups.

Examples of the oxoalkyl group include 2-oxocyclopentyl, 2-oxocyclohexyl, 2-oxopropyl, 2-cyclopentyl-2-oxoethyl, 2-cyclohexyl-2-oxoethyl, and 2-(4-methylcyclohexyl)-2-oxoethyl groups.

Examples of the oxoalkenyl group include 2-oxo-4-cyclohexenyl and 2-oxo-4-propenyl groups.

Examples of the aryl group include a phenyl group, a naphthyl group, alkoxyphenyl groups such as p-methoxyphenyl, m-methoxyphenyl, o-methoxyphenyl, ethoxyphenyl, p-tert-butoxyphenyl, and m-tert-butoxyphenyl groups, alkylphenyl groups such as 2-methylphenyl, 3-methylphenyl, 4-methylphenyl, ethylphenyl, 4-tert-butylphenyl, 4-butylphenyl, and dimethylphenyl groups, alkylnaphthyl groups such as methylnaphthyl and ethylnaphthyl groups, alkoxynaphthyl groups such as methoxynaphthyl and ethoxynaphthyl groups, dialkylnaphthyl groups such as dimethylnaphthyl and diethylnaphthyl groups, and dialkoxynaphthyl groups such as dimethoxynaphthyl and diethoxynaphthyl groups.

Examples of the aralkyl group include benzyl, phenylethyl, and phenethyl groups.

Examples of the aryl oxoalkyl group include 2-aryl-2-oxoethyl groups such as 2-phenyl-2-oxoethyl, 2-(1-naphthyl)-2-oxoethyl, and 2-(2-naphthyl)-2-oxoethyl groups.

When R¹⁰, R¹¹, R¹², and R¹³ form a heteroaromatic ring containing in it the nitrogen atom in the formula, examples of the heteroaromatic ring include imidazole derivatives (e.g., imidazole, 4-methylimidazole, and 4-methyl-2-phenylimidazole), pyrazole derivatives, furazan derivatives, pyrroline derivatives (e.g., pyrroline and 2-methyl-1-pyrroline), pyrrolidine derivatives (e.g., pyrrolidine, N-methylpyrrolidine, pyrrolidinone, and N-methylpyrrolidone), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridone, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline and 3-quinolinecarbonitrile), isoquinoline derivatives, cinnoline derivatives, quinazoline derivatives, quinoxaline derivatives, phthalazine derivatives, purine derivatives, pteridin derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivative, and uridine derivatives.

Examples of the above non-nucleophilic counter ion X⁻ include halide ions such as chloride and bromide ions, fluoroalkyl sulfonates such as triflate, 1,1,1-trifluoroethanesulfonate, and nonafluorobutanesulfonate, aryl sulfonates such as tosylate, benzenesulfonate, 4-fluorobenzenesulfonate, and 1,2,3,4,5-pentafluorobenzenesulfonate, alkyl sulfonates such as mesylate and butanesulfonate, imidates such as bis(trifluoromethylsulfonyl)imide, bis(perfluoroethylsulfonyl)imide and bis(perfluorobutylsulfonyl)imide, and methidates such as tris(trifluoromethylsulfonyl)methide and tris(perfluoroethylsulfonyl)methide. Examples further include sulfonates which are fluorinated at α-position shown by the following general formula (7) and sulfonates which are fluorinated at α- and β-positions shown by the following general formula (8).

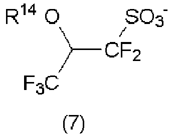

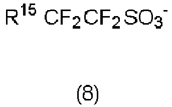

In the above general formula (7), R¹⁴ is a hydrogen atom, a linear, branched, or cyclic alkyl group having 1 to 23 carbon atoms, an acyl group, an alkenyl group having 2 to 20 carbon atoms, an aryl group having 6 to 20 carbon atoms, or an aryloxy group. In the above general formula (8), R¹⁵ is a hydrogen atom, a linear, branched, or cyclic alkyl group having 1 to 20 carbon atoms, an alkenyl group having 2 to 20 carbon atoms, or an aryl group having 6 to 20 carbon atoms.

Specific examples of the above thermal acid generator include, but not limited to, the following:

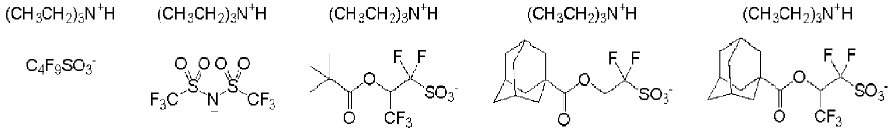

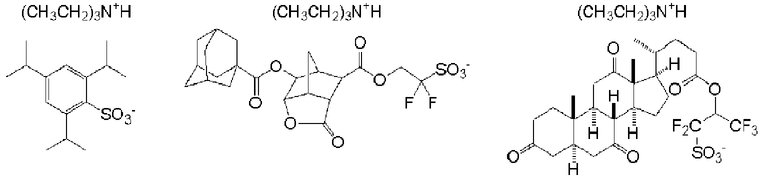

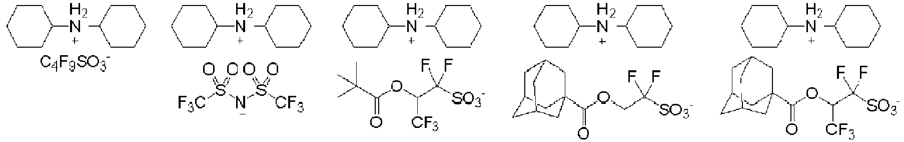

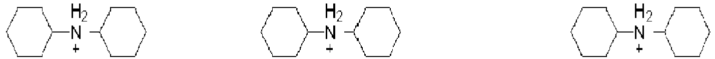

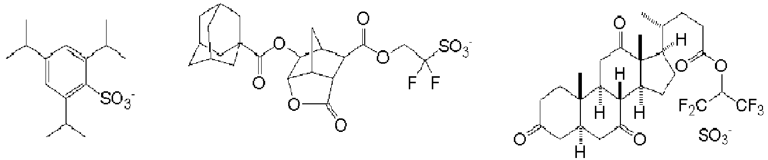

The thermal acid generator (C) contained in the inventive composition for forming an adhesive film can be of a single kind or a mixture of two or more kinds. The amount of thermal acid generator added is preferably 0.05 to 30 parts, more preferably 0.1 to 10 parts, relative to 100 parts of the above polymer (A). The addition of 0.05 parts or more will provide sufficient acid generation and crosslinking reaction, while the addition of 30 parts or less will reduce the risk of mixing phenomenon due to acid migrating to the upper layer resist.

### (D) Photo Acid Generator

A photo acid generator (D) can be added to the composition for forming an adhesive film in order to appropriately adjust the pattern profile, exposure sensitivity, etc. of the resist upper layer film. The photo acid generator can be of a single kind or a mixture of two or more kinds. For example, photo acid generators disclosed in paragraphs [0160]-[0179] of JP 2009-126940 A can be used. The amount of photo acid generator added is preferably 0.05 to 30 parts, more preferably 0.1 to 10 parts, relative to 100 parts of the above polymer (A). The addition of the photo acid generator in the amount within such ranges will ensure good resolution, eliminating the problem of foreign substances occurring after resist development or during delamination.

### (E) Crosslinking agent

(E) a crosslinking agent can also be added to the inventive composition for forming an adhesive film in order to enhance the curability and to further inhibit intermixing with the resist upper layer film. Any known crosslinking agent of various types can be generally used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. The crosslinking agent (E) can be of a single kind or a mixture of two or more kinds. The amount of crosslinking agent added is preferably 5 to 50 parts, more preferably 10 to 40 parts, relative to 100 parts of the above polymer (A). The addition of 5 parts or more will produce sufficient curability, making it possible to inhibit intermixing with the resist upper layer. On the other hand, the addition of 50 parts or less will eliminate the risk of adhesion degradation due to a decreased ratio of the polymer (A) in the composition.

Examples of the melamine-based crosslinking agent include hexamethoxymethylated melamine, hexabutoxymethylated melamine, alkoxy and/or hydroxy substitutes thereof, and partial self-condensates thereof.

Specific examples of the glycoluril-based crosslinking agents include tetramethoxymethylated glycoluril, tetrabutoxymethylated glycoluril, alkoxy and/or hydroxy substitutes thereof, and partial self-condensates thereof.

Specific examples of the benzoguanamine-based crosslinking agents include tetramethoxymethylated benzoguanamine, tetrabutoxymethylated benzoguanamine, alkoxy and/or hydroxy substitutes thereof, and partial self-condensates thereof.

Specific examples of the urea-based crosslinking agents include dimethoxymethylated dimethoxyethyleneurea, alkoxy and/or hydroxy substitutes thereof, and partial self-condensates thereof.

Specific examples of the β-hydroxyalkylamide-based crosslinking agents include N,N,N',N'-tetra(2-hydroxyethyl)adipate amide.

Specific examples of the isocyanurate-based crosslinking agents include triglycidylisocyanurate and triallylisocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate] .

Specific examples of the oxazoline-based crosslinking agents include 2,2'-isopropylidene-bis(4-benzyl-2-oxazoline), 2,2'-isopropylidene-bis(4-phenyl-2-oxazoline), 2,2'-methylene-bis(4,5-diphenyl-2-oxazoline), 2,2'-methylene-bis(4-phenyl-2-oxazoline), 2,2'-methylene-bis(4-tert-butyl-2-oxazoline), 2,2'-bis(2-oxazoline), 1,3-phenylene-bis(2-oxazoline), 1,4-phenylene-bis(2-oxazoline), and copolymers of 2-isopropenyloxazoline.

Specific examples of the epoxy-based crosslinking agents include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

Specific examples of the phenol-based crosslinking agents include a compound shown by the following general formula (9), 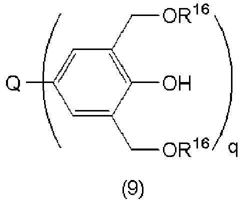 wherein Q is a single bond or a q-valent hydrocarbon group having 1 to 20 carbon atoms, and R¹⁶ is a hydrogen atom or an alkyl group having 1 to 20 carbon atoms, where q is an integer of 1 to 5.

Q is a single bond or a q-valent hydrocarbon group having 1-20 carbon atoms, where q is an integer of 1 to 5, more preferably 2 or 3. Specific examples of Q include methane, ethane, propane, butane, isobutane, pentane, cyclopentane, hexane, cyclohexane, methyl pentane, methyl cyclohexane, dimethyl cyclohexane, trimethyl cyclohexane, benzene, toluene, xylene, ethyl benzene, ethylisopropylbenzene, diisopropylbenzene, methylnaphthalene, ethylnaphthalene, and eicosane. R¹⁶ is a hydrogen atom or an alkyl group having 1 to 20 carbon atoms. Specific examples of the alkyl group having 1 to 20 carbon atoms include methyl, ethyl, propyl, isopropyl, butyl, isobutyl, pentyl, isopentyl, hexyl, octyl, ethylhexyl, decyl, and eicosanyl groups, and a hydrogen atom or a methyl group is preferred.

Specific examples of the compound shown by the general formula (9) include the following compounds. Preferred among these are triphenolmethane, triphenolethane, 1,1,1-tris(4-hydroxyphenyl)ethane, and tris(4-hydroxyphenyl)-1-ethyl-4-isopropylbenzene that are hexamethoxymethylated, from the viewpoint of providing curability of the adhesive film and improving the film thickness uniformity.

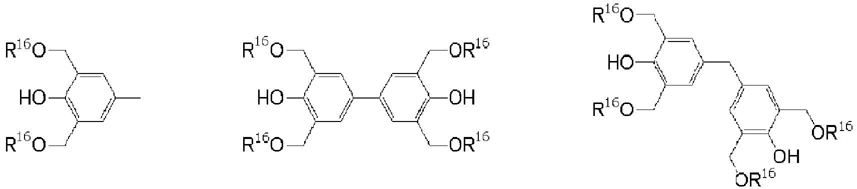

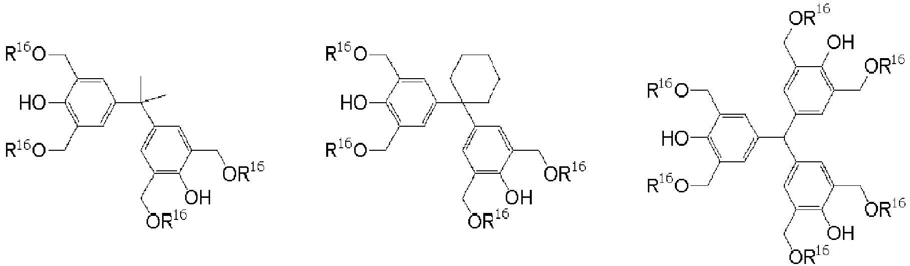

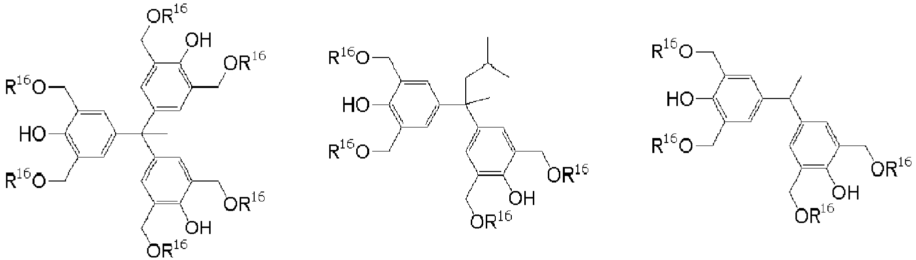

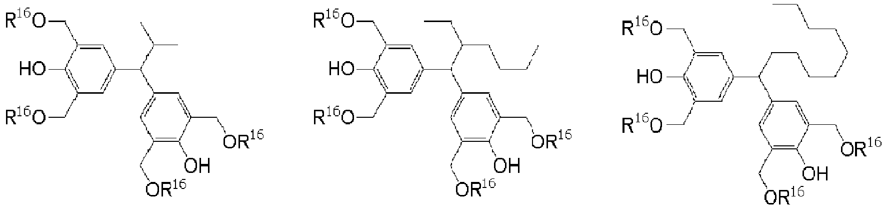

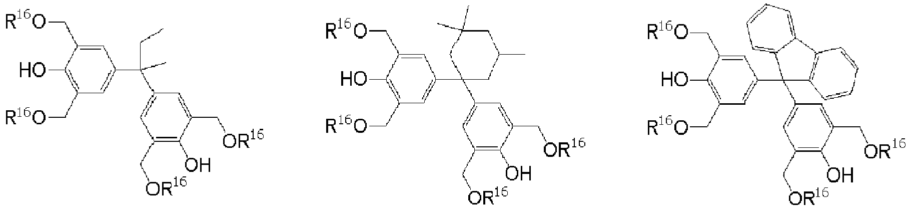

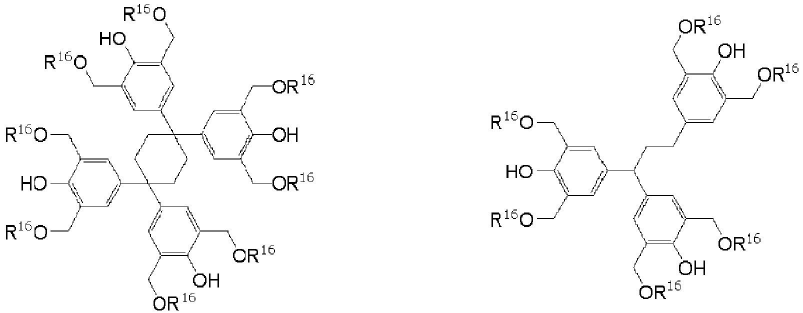

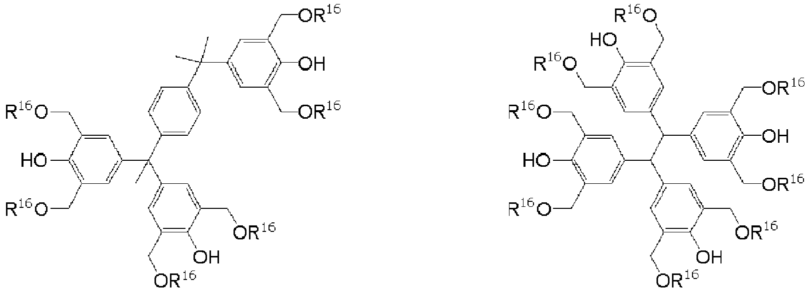

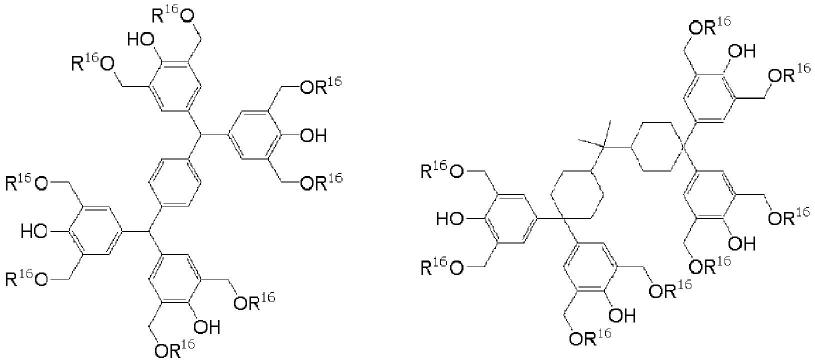

The above crosslinking agent (E) can be of a single kind or a mixture of two or more kinds. The amount of crosslinking agent (E) added is preferably 10 mass% to 50 mass%, more preferably 15 mass% to 30 mass%, relative to 100 parts of the above polymer (A). The addition of 10 mass% or more will provide sufficient curability, making it possible to inhibit intermixing with the resist upper layer film. On the other hand, the addition of 50 mass% or less will eliminate the risk of adhesion degradation as the ratio of the polymer (A) in the composition will not be decreased.

### (F) Surfactant

(F) a surfactant can be added to the inventive composition for forming an adhesive film in order to improve the coatability in spin-coating. The surfactant can be of a single kind or a mixture of two or more kinds. For example, those disclosed in paragraphs [0142]-[0147] of JP 2009-269953 A can be used as the surfactant. The amount of surfactant added is preferably 0.001 to 20 parts, more preferably 0.01 to 10 parts, relative to 100 parts of the polymer (A). The addition within such ranges will surely improve the coatability, making it possible to form a thin and uniform adhesive film.

A plasticizer can also be added to the inventive composition for forming an adhesive film. Any known plasticizer of various types can be generally used. Examples include low molecular weight compounds such as phthalates, adipates, phosphates, trimellitates, and citrates, and polymers such as polyethers, polyesters, and polyacetal-based polymers disclosed in JP 2013-253227 A. The amount of plasticizer added is preferably 5 mass% to 500 mass%, relative to 100 parts of the above polymer (A). The addition within such a range will provide excellent pattern filling and planarizing properties.

The inventive composition for forming an adhesive film is extremely useful in multilayer resist processes, such as a two-layer resist process and a four-layer resist process that uses a resist underlayer film and a silicon-containing middle layer film.

The above silicon-containing middle layer film can be a silicon-containing resist middle layer film or an inorganic hard mask middle layer film, depending on the patterning process described below. The inorganic hard mask middle layer film is preferably selected from a silicon oxide film, a silicon nitride film, and a silicon oxynitride film.

### Method for Forming an Adhesive Film

The present invention provides a method of forming, using the aforementioned composition for forming an adhesive film, an adhesive film that has high adhesion to the resist upper layer film to have an effect of inhibiting collapse of fine patterns in a fine patterning process by a multilayer resist method during semiconductor apparatus manufacturing processes.

In the inventive method for forming an adhesive film, a substrate to be processed is coated with the above composition for forming an adhesive film by a spin-coating method or the like. After the spin-coating, baking (heat treatment) is performed to evaporate the organic solvent and facilitate a crosslinking reaction to prevent intermixing with the resist upper layer film or the silicon-containing middle layer film. The baking is preferably performed at 100°C or higher and 300°C or lower for 10 to 600 seconds, more preferably at 200°C or higher and 250°C or lower for 10 to 300 seconds. Considering the damage to the adhesive film and the effect on deformation of the wafer, the upper limit of the heating temperature in the lithography wafer process is preferably 300°C or lower, more preferably 250°C or lower.

That is, the present invention provides a method for forming an adhesive film that serves as an adhesive layer employed in a semiconductor apparatus manufacturing process, where the method includes spin-coating a substrate to be processed with the aforementioned composition for forming an adhesive film; and heating the substrate coated with the composition for forming an adhesive film at a temperature of 100°C or higher and 300°C or lower for 10 to 600 seconds to form an adhesive film.

The inventive method for forming an adhesive film can also form an adhesive film by coating a substrate to be processed with the inventive composition for forming an adhesive film by a spin-coating method or the like, similarly to the above, and then baking and curing the composition for forming an adhesive film in an atmosphere having an oxygen concentration of 0.1% or more and 21% or less. Baking the inventive composition for forming an adhesive film in such an oxygen atmosphere can yield a sufficiently cured film.

That is, the present invention provides a method for forming an adhesive film that serves as an adhesive layer employed in a semiconductor apparatus manufacturing process, where the method includes: spin-coating a substrate to be processed with the aforementioned composition for forming an adhesive film; and heating the substrate coated with the composition for forming an adhesive film in an atmosphere having an oxygen concentration of 0.1% or more and 21% or less to form an adhesive film.

Besides an air atmosphere, the baking may be performed under an atmosphere with introduction of an inert gas such as N₂, Ar, and He. In such cases, the atmosphere can have an oxygen concentration of less than 0.1%. The baking temperature and other conditions can be the same as above. In this manner, the crosslinking reaction during the adhesive film formation can be facilitated without causing any degradation of the substrate to be processed even when the substrate to be processed contains any material that is heat labile under an oxygen atmosphere.

That is, the present invention provides a method for forming an adhesive film that serves as an adhesive layer employed in a semiconductor apparatus manufacturing process, where the method includes: spin-coating a substrate to be processed with the aforementioned composition for forming an adhesive film; and heating the substrate coated with the composition for forming an adhesive film in an atmosphere having an oxygen concentration of less than 0.1% to form an adhesive film.

### Patterning Process

The present invention provides a patterning process for forming a pattern in a substrate to be processed, including the steps of:
(I-1) applying the aforementioned composition for forming an adhesive film on the substrate to be processed and then performing a heat treatment to form an adhesive film;
(I-2) forming a resist upper layer film on the adhesive film by using a composition for forming a resist upper layer film;
(I-3) subjecting the resist upper layer film to pattern exposure and then to development with a developer to form a circuit pattern in the resist upper layer film; and
(I-4) transferring the pattern to the adhesive film and the substrate to be processed by dry etching while using the resist upper layer film having the formed circuit pattern as a mask.

The inventive patterning process is described below, by way of example with respect to a four-layer resist process, though the present invention is not limited to such a process. First, the present invention provides a patterning process for forming a pattern on a substrate to be processed. The process at least includes: forming a resist underlayer film on the substrate to be processed by using a composition for forming an organic film; forming a silicon-containing middle layer film (silicon-containing resist middle layer film) on the resist underlayer film by using a composition for forming a resist middle layer film containing a silicon atom; forming an adhesive film on the silicon-containing resist middle layer film by using the inventive composition for forming an adhesive film; forming a resist upper layer film on the adhesive film by using a composition for forming a resist upper layer film, so that a multilayer resist film is formed; subjecting a pattern circuit region of the resist upper layer film to exposure and then to development with a developer to form a pattern of the resist upper layer film; etching the adhesive film and the silicon-containing resist middle layer film while using the obtained resist upper layer film pattern as an etching mask to form a silicon-containing resist middle layer film pattern; etching the resist underlayer film while using the obtained silicon-containing resist middle layer film pattern as an etching mask to form a resist underlayer film pattern; and etching the substrate to be processed while using the obtained resist underlayer film pattern as an etching mask to form a pattern in the substrate to be processed.

That is, the present invention provides a patterning process for forming a pattern in a substrate to be processed, including the steps of:
(II-1) forming a resist underlayer film on the substrate to be processed;
(II-2) forming a silicon-containing resist middle layer film on the resist underlayer film;
(II-3) applying the aforementioned composition for forming an adhesive film on the silicon-containing resist middle layer film and then performing a heat treatment to form an adhesive film;
(II-4) forming a resist upper layer film on the adhesive film by using a composition for forming a resist upper layer film;
(II-5) subjecting the resist upper layer film to pattern exposure and then to development with a developer to form a circuit pattern in the resist upper layer film;
(II-6) transferring the pattern to the adhesive film and the silicon-containing resist middle layer film by dry etching while using the resist upper layer film having the formed circuit pattern as a mask;
(II-7) transferring the pattern to the resist underlayer film by dry etching while using the silicon-containing resist middle layer film having the transferred pattern as a mask; and
(II-8) forming the pattern in the substrate to be processed by processing the substrate to be processed while using the resist underlayer film having the transferred pattern as a mask.

A polysilsesquioxane-based middle layer film is also a preferred choice as the silicon-containing resist middle layer film for the four-layer resist process. Providing an antireflection effect to the silicon-containing resist middle layer film can inhibit reflection. For 193-nm exposure in particular, while the use of a material rich in aromatic groups and having a high substrate etching resistance as the resist underlayer film results in a high k value and high substrate reflection, the use of the silicon-containing resist middle layer film can reduce the substrate reflectance to 0.5% or less. As the silicon-containing resist middle layer film with an antireflection effect, preferred choices include acid or heat-crosslinkable polysilsesquioxane having anthracene as pendants for 248-nm and 157-nm exposure, and having a phenyl group or a light-absorbing group with a silicon-silicon bond as pendants for 193-nm exposure.

In such cases, forming the silicon-containing resist middle layer film by a spin-coating method is a simpler and more cost-effective approach than using CVD methods.

Alternatively, an inorganic hard mask middle layer film may be formed as the silicon-containing resist middle layer film. In such cases, a pattern can be formed in the substrate to be processed by performing at least the following: forming a resist underlayer film on the substrate to be processed by using a composition for forming an organic film; forming an inorganic hard mask middle layer film selected from a silicon oxide film, a silicon nitride film, and a silicon oxynitride film on the resist underlayer film; forming an adhesive film on the inorganic hard mask middle layer film by using the inventive composition for forming an adhesive film; forming a resist upper layer film on the adhesive film by using a composition for forming a photoresist upper layer film; subjecting a pattern circuit region of the resist upper layer film to exposure and then to development with a developer to form a resist upper layer film pattern in the resist upper layer film; etching the adhesive film and the inorganic hard mask middle layer film while using the obtained resist upper layer film pattern as an etching mask to form an inorganic hard mask middle layer film pattern; etching the resist underlayer film while using the obtained inorganic hard mask middle layer film pattern as an etching mask to form a resist underlayer film pattern; and etching the substrate to be processed while using the obtained resist underlayer film pattern as an etching mask to form a pattern in the substrate to be processed.

That is, the present invention provides a patterning process for forming a pattern in a substrate to be processed, including the steps of:
(III-1) forming a resist underlayer film on the substrate to be processed;
(III-2) forming an inorganic hard mask middle layer film selected from a silicon oxide film, a silicon nitride film, and a silicon oxynitride film on the resist underlayer film;
(III-3) applying the inventive composition for forming an adhesive film on the inorganic hard mask middle layer film and then performing a heat treatment to form an adhesive film;
(III-4) forming a resist upper layer film on the adhesive film by using a composition for forming a resist upper layer film;
(III-5) subjecting the resist upper layer film to pattern exposure and then to development with a developer to form a circuit pattern in the resist upper layer film;
(III-6) transferring the pattern to the adhesive film and the inorganic hard mask middle layer film by dry etching while using the resist upper layer film having the formed circuit pattern as a mask;
(III-7) transferring the pattern to the resist underlayer film by dry etching while using the inorganic hard mask middle layer film with the transferred pattern as a mask; and
(III-8) forming the pattern in the substrate to be processed by processing the substrate to be processed while using the resist underlayer film having the transferred pattern as a mask.

When an inorganic hard mask middle layer film is formed on the resist underlayer film as described above, a silicon oxide film, a silicon nitride film, and a silicon oxynitride film (SiON film) can be formed by methods such as a CVD method or an ALD method. It is particularly preferred to form the inorganic hard mask middle layer film by a CVD method or an ALD method. Example methods for forming a silicon nitride film are disclosed in JP 2002-334869 A and WO 2004/066377 A1. The inorganic hard mask middle layer film preferably has a film thickness of 5 to 200 nm, more preferably 10 to 100 nm. A SiON film, which is highly effective as an antireflective film, is a most preferred choice as the inorganic hard mask middle layer film. Since the substrate temperature reaches 300 to 500°C during the formation of a SiON film, the resist underlayer film is required to withstand the temperature of 300 to 500°C.

The resist upper layer film in the above four-layer process can be either of a positive type or a negative type. Preferably, the resist upper layer film is formed by using a composition for forming a resist upper layer film that at least contains a metal atom-containing compound and an organic solvent, and more preferably, the metal atom-containing compound contains at least one element selected from titanium, cobalt, copper, zinc, zirconium, lead, indium, tin, antimony and hafnium. After the spin-coating of the composition for forming a photoresist upper layer film, pre-baking is performed, preferably at 60 to 180°C for 10 to 300 seconds. Then, exposure, post-exposure baking (PEB), and development are performed according to usual methods to obtain the resist upper layer film pattern. The thickness of the resist upper layer film is, but not limited to, preferably 20 to 300 nm, more preferably 25 to 250 nm.

A circuit pattern (resist upper layer film pattern) is formed in the resist upper layer film. The circuit pattern is preferably formed by using photolithography at a wavelength of 10 nm or more and 300 nm or less, a direct drawing by electron beam, a nanoimprinting, or a combination thereof.

The exposure light may be any high energy beam with a wavelength of 300 nm or less, which specifically includes far-ultraviolet rays, KrF excimer laser light (248 nm), ArF excimer laser light (193 nm), F₂ laser light (157 nm), Kr₂ laser light (146 nm), Ar₂ laser light (126 nm), soft X-rays of 3 to 20 nm (EUV), electron beams (EB), ion beams, X-rays, etc.

In forming the circuit pattern, alkaline development or development with an organic solvent is preferably used to develop the circuit pattern.

Then, etching is performed while using the obtained resist upper layer film as a mask. The adhesive film formed from the inventive composition for forming an adhesive film has a high etching rate due to minimized alicyclic structure and aromatic rings and can be used for thin films of 15 nm or less, so that it can reduce the etching road on the resist pattern used as a mask. Accordingly, the adhesive film and the film directly under it, e.g., the silicon-containing resist middle layer film or the inorganic hard mask middle layer film, can be etched based on the resist upper layer film pattern. These silicon-containing resist middle layer film and inorganic hard mask middle layer film are etched with a fluorocarbon-based gas. In this manner, a silicon-containing resist middle layer film pattern or an inorganic hard mask middle layer film pattern is formed.

Then, the resist underlayer film is etched while using the obtained silicon-containing resist middle layer film pattern or inorganic hard mask middle layer film pattern as a mask.

Subsequent etching of the substrate to be processed can also be performed by any usual method. For example, a substrate to be processed made of SiO₂, SiN, or a silica-based low-k insulating film is subjected to etching based on a fluorocarbon-based gas, and a substrate to be processed made of p-Si, Al, or W is subjected to etching based on a chlorine- or bromine-based gas. Etching the substrate with a fluorocarbon-based gas allows the silicon-containing middle layer film pattern to be removed along with the substrate processing. In the case of etching the substrate with a chlorine- or bromine-based gas, the silicon-containing middle layer film pattern needs to be delaminated by a separate dry etching process with a fluorocarbon-based gas after the substrate processing.

The substrate to be processed is not limited to a particular substrate, and can be a semiconductor apparatus substrate or the semiconductor apparatus substrate coated with any of a metal film, a metal carbide film, a metal oxide film, a metal nitride film, a metal oxycarbide film, and a metal oxynitride film. The metal may be silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof.

Specific examples include substates made of Si, α-Si, p-Si, SiO₂, SiN, SiON, W, TiN, Al, etc. as well as these substrates coated with a layer to be processed. Examples of the layer to be processed include various low-k films made of Si, SiO₂, SiON, SiN, p-Si, α-Si, W, W-Si, Al, Cu, Al-Si, etc., and stopper films thereof. Such layers can generally be formed to be 50 to 10,000 nm thick, particularly 100 to 5,000 nm thick. When the layer to be processed is formed, different materials are used for the substrate and the layer to be processed.

A specific example of the four-layer resist process is shown below with reference to FIG. 1. As shown in FIG. 1(A), in the four-layer resist process, a resist underlayer film 3 is formed by using an organic film material on a layer to be processed 2 laminated on a substrate 1. Then, a silicon-containing middle layer film 4 is formed, and an adhesive film 5 is formed thereon by using the inventive composition for forming an adhesive film, followed by forming a resist upper layer film 6 thereon.

Then, as shown in FIG. 1(B), an exposed portion 7 of the resist upper layer film is exposed, followed by PEB and development to form a resist upper layer film pattern 6a (FIG. 1(C)). Using the obtained resist upper layer film pattern 6a as a mask, the adhesive film 5 is etched to form an adhesive film pattern 5a (FIG. 1(D)), and further the silicon-containing middle layer film 4 is etched with a CF-based gas to form a silicon-containing middle layer film pattern 4a (FIG. 1(E)). Using the obtained silicon-containing middle layer film pattern 4a as a mask, the resist underlayer film 3 is etched with an O₂-based gas to form a resist underlayer film pattern 3a (FIG. 1(F)). Then, the silicon-containing middle layer film pattern 4a is removed, followed by etching the layer to be processed 2 while using the resist underlayer film pattern 3a as a mask to thereby form a pattern 2a (FIG. 1(G)).

In this manner, the inventive patterning process can form a fine pattern with high precision in the substrate to be processed in the multilayer resist process.

### EXAMPLE

The present invention will now be further detailed with reference to Synthesis Examples, Examples, and Comparative Examples, though the present invention is not limited to these examples. The molecular weight was measured by gel permeation chromatography (GPC) using tetrahydrofuran (THF) as an eluent, and the dispersity (Mw/Mn) was calculated from the polystyrene-equivalent weight average molecular weight (Mw) and number average molecular weight (Mn).

Polymers (A1) to (A10) and comparative polymers (A11), (A12) were synthesized as the polymers (A) for the composition for forming an adhesive film. The following monomers (1'-1) to (1'-4), (2'-1) to (2'-4), and (3'-1), (3'-2) were used to prepare these polymers.

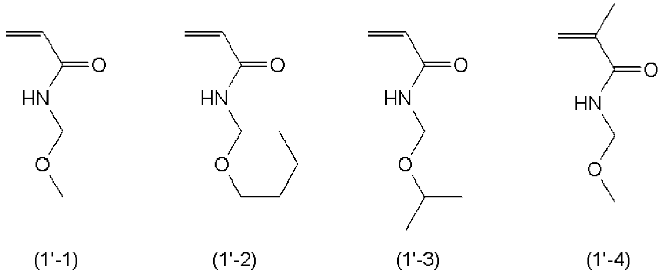

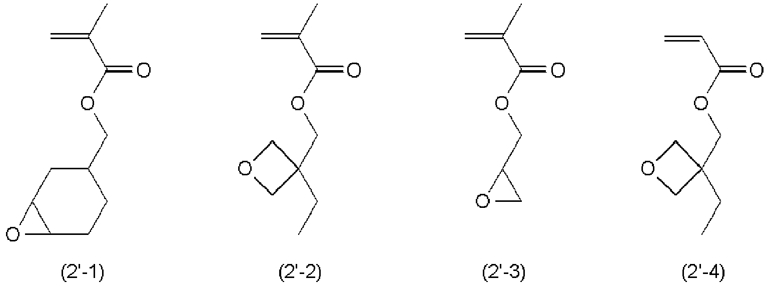

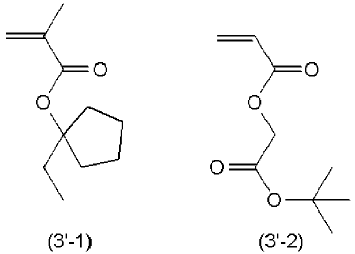

### Synthesis Example 1: Synthesis of Polymer (A1)

Propylene glycol monomethyl ether acetate (hereinafter referred to as "PGMEA"), 100.0 g, was stirred with heating at 80°C under a nitrogen atmosphere. To this were added, simultaneously and separately over 4 hours, a mixture of 12.8 g of the monomer (1'-1), 87.2 g of the monomer (2'-1), and 100.0 g of PGMEA, and a mixture of 6.40 g of dimethyl 2,2-azobis(2-methylpropionate) (V-601 available from Wako Pure Chemical Industries Ltd.) and 100.0 g of PGMEA. The resulting mixture was further stirred with heating for 20 hours and then cooled to room temperature, resulting in a PGMEA solution of the intended polymer (A1). The GPC analysis showed that the weight average molecular weight (Mw) and dispersity (Mw/Mn) of the polymer (A1) were 11,000 and 2.0, respectively.

### Synthesis Example 2: Synthesis of Polymer (A2)

PGMEA (100.0g) was stirred with heating at 80°C under a nitrogen atmosphere. To this were added, simultaneously and separately over 4 hours, a mixture of 71.4 g of the monomer (1'-1), 28.6 g of the monomer (2'-2), and 100.0 g of PGMEA, and a mixture of 8.92 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A2). The GPC analysis showed that the weight average molecular weight (Mw) and dispersity (Mw/Mn) of the polymer (A2) were 19,000 and 2.5, respectively.

### Synthesis Example 3: Synthesis of Polymer (A3)

PGMEA (100.0g) was stirred with heating at 80°C under a nitrogen atmosphere. To this were added, simultaneously and separately over 4 hours, a mixture of 32.2 g of the monomer (1'-2), 67.8 g of the monomer (2'-3), and 100.0 g of PGMEA, and a mixture of 7.85 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A3). The GPC analysis showed that the weight average molecular weight (Mw) and dispersity (Mw/Mn) of the polymer (A3) were 12,000 and 2.0, respectively.

### Synthesis Example 4: Synthesis of Polymer (A4)

PGMEA (100.0g) was stirred with heating at 80°C under a nitrogen atmosphere. To this were added, simultaneously and separately over 4 hours, a mixture of 72.1 g of the monomer (1'-2), 27.9 g of the monomer (2'-3), and 100.0 g of PGMEA, and a mixture of 7.54 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A4). The GPC analysis showed that the weight average molecular weight (Mw) and dispersity (Mw/Mn) of the polymer (A4) were 19,000 and 2.5, respectively.

### Synthesis Example 5: Synthesis of Polymer (A5)

PGMEA (100.0g) was stirred with heating at 80°C under a nitrogen atmosphere. To this were added, simultaneously and separately over 4 hours, a mixture of 52.5 g of the monomer (1'-2), 47.5 g of the monomer (2'-3), and 100.0 g of PGMEA, and a mixture of 7.69 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A5). The GPC analysis showed that the weight average molecular weight (Mw) and dispersity (Mw/Mn) of the polymer (A5) were 17,000 and 2.4, respectively.

### Synthesis Example 6: Synthesis of Polymer (A6)

PGMEA (100.0g) was stirred with heating at 90°C under a nitrogen atmosphere. To this were added, simultaneously and separately over 4 hours, a mixture of 52.5 g of the monomer (1'-2), 47.5 g of the monomer (2'-3), and 100.0 g of PGMEA, and a mixture of 15.38 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A6). The GPC analysis showed that the weight average molecular weight (Mw) and dispersity (Mw/Mn) of the polymer (A6) were 8,000 and 1.9, respectively.

### Synthesis Example 7: Synthesis of Polymer (A7)

PGMEA (100.0g) was stirred with heating at 100°C under a nitrogen atmosphere. To this were added, simultaneously and separately over 4 hours, a mixture of 52.5 g of the monomer (1'-2), 47.5 g of the monomer (2'-3), and 100.0 g of PGMEA, and a mixture of 15.38 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A7). The GPC analysis showed that the weight average molecular weight (Mw) and dispersity (Mw/Mn) of the polymer (A7) were 6,000 and 1.8, respectively.

### Synthesis Example 8: Synthesis of Polymer (A8)

PGMEA (100.0g) was stirred with heating at 80°C under a nitrogen atmosphere. To this were added, simultaneously and separately over 4 hours, a mixture of 35.4 g of the monomer (1'-3), 42.1 g of the monomer (2'-4), 22.5 g of the monomer (3'-1), and 100.0 g of PGMEA, and a mixture of 7.12 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A8). The GPC analysis showed that the weight average molecular weight (Mw) and dispersity (Mw/Mn) of the polymer (A8) were 19,000 and 2.4, respectively.

### Synthesis Example 9: Synthesis of Polymer (A9)

PGMEA (100.0g) was stirred with heating at 80°C under a nitrogen atmosphere. To this were added, simultaneously and separately over 4 hours, a mixture of 35.4 g of the monomer (1'-4), 39.0 g of the monomer (2'-3), 25.7 g of the monomer (3'-2),and 100.0 g of PGMEA, and a mixture of 7.90 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A9). The GPC analysis showed that the weight average molecular weight (Mw) and dispersity (Mw/Mn) of the polymer (A9) were 12,000 and 2.1, respectively.

### Synthesis Example 10: Synthesis of Polymer (A10)

PGMEA (100.0g) was stirred with heating at 80°C under a nitrogen atmosphere. To this were added, simultaneously and separately over 4 hours, a mixture of 48.0 g of the monomer (1'-2), 52.0 g of the monomer (2'-4), and 100.0 g of PGMEA, and a mixture of 7.03 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A10). The GPC analysis showed that the weight average molecular weight (Mw) and dispersity (Mw/Mn) of the polymer (A10) were 15,000 and 3.0, respectively.

### Synthesis Example 11: Synthesis of Polymer (A11)

PGMEA (100.0g) was stirred with heating at 80°C under a nitrogen atmosphere. To this were added, simultaneously and separately over 4 hours, a mixture of 100.0 g of the monomer (1'-2) and 100.0 g of PGMEA, and a mixture of 7.32 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A11). The GPC analysis showed that the weight average molecular weight (Mw) and dispersity (Mw/Mn) of the polymer (A11) were 20,000 and 2.9, respectively.

### Synthesis Example 12: Synthesis of Polymer (A12)

PGMEA (100.0g) was stirred with heating at 80°C under a nitrogen atmosphere. To this were added, simultaneously and separately over 4 hours, a mixture of 100.0 g of the monomer (2'-3) and 100.0 g of PGMEA, and a mixture of 8.10 g of dimethyl 2,2-azobis(2-methylpropionate) and 100.0 g of PGMEA. The resulting mixture was further stirred with heating for 20 hours and then cooled to room temperature, resulting in a PGMEA solution of the intended polymer (A12). The GPC analysis showed that the weight average molecular weight (Mw) and dispersity (Mw/Mn) of the polymer (A12) were 10,000 and 2.0, respectively.

The synthesized polymers described above are summarized in Table 1 below.

**[Table 1]**

| Synth. Ex. | Polymer | Monomer (1') | Monomer (2') | Monomer (3') | Mw | Mw/Mn |
|---|---|---|---|---|---|---|
| 1 | (A1) | (1'-1) 20mol% | (2'-1) 80mol% | | 11,000 | 2.0 |
| 2 | (A2) | (1'-1) 80mol% | (2'-2) 20mol% | | 19,000 | 2.5 |
| 3 | (A3) | (1'-2) 30mol% | (2'-3) 70mol% | | 12,000 | 2.0 |
| 4 | (A4) | (1'-2) 70mol% | (2'-3) 30mol% | | 19,000 | 2.5 |
| 5 | (A5) | (1'-2) 50mol% | (2'-3) 50mol% | | 17,000 | 2.4 |
| 6 | (A6) | (1'-2) 50mol% | (2'-3) 50mol% | | 8,000 | 1.9 |
| 7 | (A7) | (1'-2) 50mol% | (2'-3) 50mol% | | 6,000 | 1.8 |
| 8 | (A8) | (1'-3) 40mol% | (2'-4) 40mol% | (3'-1) 20mol% | 19,000 | 2.4 |
| 9 | (A9) | (1'-4) 40mol% | (2'-3) 40mol% | (3'-2) 20mol% | 12,000 | 2.1 |
| 10 | (A10) | (1'-2) 50mol% | (2'-4) 50mol% | | 15,000 | 3.0 |
| 11 | (A11) | (1'-2) 100mol% | | | 20,000 | 2.9 |
| 12 | (A12) | | (2'-3) 100mol% | | 10,000 | 2.0 |

### Preparation of Compositions (AL1 to 16, Comparative AL1 to 3) for Forming an Adhesive Film

The above polymers (A1) to (A12), thermal acid generators (AG1) to (AG3), photo acid generators (AG4), (AG5), and crosslinking agents (X1), (X2) were used for preparation of the respective compositions for forming an adhesive film. These materials were dissolved in an organic solvent containing 0.001 mass% of PF636 (available from OMNOVA) in the proportions shown in Tables 2, 3. The resulting solutions were filtered through a 0.1-pm fluoroplastic filter to prepare the respective compositions (AL1 to 16, comparative AL1 to 3) for forming an adhesive film.

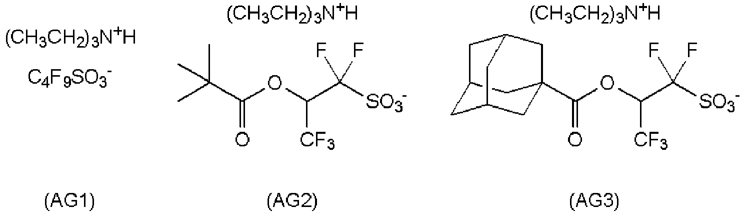

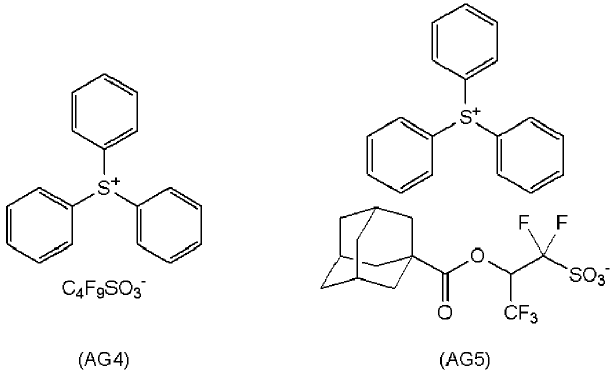

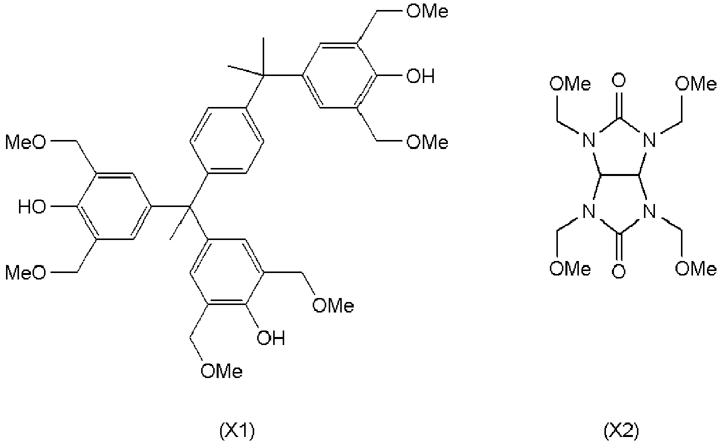

**[Table 2]**

| Composition for forming adhesive film | Polymer (mass%) | Thermal acid generator (mass%) | Photo acid generator (mass%) | Crosslinking agent (mass%) | Organic solvent (mass%) |
|---|---|---|---|---|---|
| AL1 | A1 (10) | AG1 (0.2) | | X1 (0.5) | PGMEA (3,200) |
| AL2 | A1 (10) | AG1 (0.2) | AG4 (0.4) | | PGMEA (3,200) |
| AL3 | A2 (10) | AG1 (0.2) | AG4 (0.4) | | PGMEA (3,200) |
| AL4 | A3 (10) | AG1 (0.2) | AG4 (0.4) | | PGMEA (3,200) |
| AL5 | A3 (10) | AG2 (0.2) | | X2 (0.5) | PGMEA (3,200) |
| AL6 | A4 (10) | AG1 (0.2) | AG4 (0.4) | | PGMEA (3,200) |
| AL7 | A5 (10) | | | | PGMEA (3,200) |
| AL8 | A5 (10) | AG1 (0.2) | AG4 (0.4) | | PGMEA (3,200) |
| AL9 | A5 (10) | AG1 (0.2) | AG4 (0.4) | | PGMEA (1,400) |
| AL10 | A6 (10) | AG1 (0.2) | AG4 (0.4) | | PGMEA (3,200) |
| AL11 | A7 (10) | AG1 (0.2) | AG4 (0.4) | | PGMEA (3,200) |
| AL12 | A8 (10) | AG2 (0.2) | | | PGMEA (3,200) |
| AL13 | A8 (10) | AG2 (0.2) | | | PGMEA (1,400) |
| AL14 | A9 (10) | AG3 (0.2) | AG5 (0.4) | | PGMEA (3,200) |
| AL15 | A9 (10) | AG3 (0.2) | AG5 (0.4) | X2 (0.5) | PGMEA (3,200) |
| AL16 | A10 (10) | AG1 (0.2) | AG4 (0.4) | | PGMEA (3,200) |

**[Table 3]**

| Composition for forming adhesive film | Polymer (mass%) | Thermal acid generator (mass%) | Photo acid generator (mass%) | Crosslinking agent (mass%) | Organic solvent (mass%) |
|---|---|---|---|---|---|
| Comp. AL1 | A11 (10) | | | | PGMEA (3,200) |
| Comp. AL2 | A11 (10) | AG1 (0.2) | AG4 (0.4) | | PGMEA (3,200) |
| Comp. AL3 | A12 (10) | AG1 (0.2) | AG4 (0.4) | | PGMEA (3,200) |

### Example 1: Film Thickness Uniformity and Solvent Resistance Evaluation (Examples 1-1 to 16, Comparative Examples 1-1 to 3)

The respective compositions (AL1 to 16, comparative AL1 to 3) for forming an adhesive film prepared above described above were applied on a 300 mm silicon substrate and baked at 220°C for 60 seconds. Then, the film thickness was measured. The film thickness was measured at 225 locations across the wafer surface, and the difference between the maximum and minimum values of these measurements was determined as a parameter indicative of in-plane film thickness uniformity. A smaller value of the measurement corresponds to a higher film thickness uniformity on the wafer, which is preferred. The average film thickness value for these 225 locations was defined as the film thickness after film formation.

A PGMEA solvent was dispensed on the obtained adhesive film, left to stand for 30 seconds, spin-dried, and baked at 100°C for 60 seconds to evaporate the PGMEA solvent. Then, the film thickness was measured again. The difference between the film thicknesses before and after the PGMEA treatment was determined to evaluate the solvent resistance. The results are shown in Table 4.

**[Table 4]**

| Example | Composition for forming adhesive film | Film thickness after film formation: a(Å) | Film thickness uniformity (Å) | Film thickness after solvent treatment: b(Å) | b/a ×100 (%) |
|---|---|---|---|---|---|
| Ex. 1-1 | AL1 | 50.1 | 1.2 | 50.1 | 100.0 |
| Ex. 1-2 | AL2 | 50.2 | 1.3 | 50.0 | 99.6 |
| Ex. 1-3 | AL3 | 50.1 | 1.5 | 50.0 | 99.8 |
| Ex. 1-4 | AL4 | 50.4 | 1.3 | 50.2 | 99.6 |
| Ex. 1-5 | AL5 | 50.2 | 1.2 | 50.1 | 99.8 |
| Ex. 1-6 | AL6 | 50.3 | 1.6 | 50.2 | 99.8 |
| Ex. 1-7 | AL7 | 50.2 | 1.5 | 50.1 | 99.8 |
| Ex. 1-8 | AL8 | 50.1 | 1.5 | 50.0 | 99.8 |
| Ex. 1-9 | AL9 | 150.4 | 1.5 | 150.1 | 99.8 |
| Ex. 1-10 | AL10 | 50.3 | 1.9 | 50.2 | 99.8 |
| Ex. 1-11 | AL11 | 50.0 | 2.9 | 50.0 | 100.0 |
| Ex. 1-12 | AL12 | 50.4 | 1.6 | 50.3 | 99.8 |
| Ex. 1-13 | AL13 | 150.5 | 1.5 | 150.4 | 99.9 |
| Ex. 1-14 | AL14 | 50.2 | 1.1 | 50.1 | 99.8 |
| Ex. 1-15 | AL15 | 50.0 | 1.2 | 50.0 | 100.0 |
| Ex. 1-16 | AL16 | 50.3 | 2.6 | 50.2 | 99.8 |
| Comp. Ex. 1-1 | Comp. AL1 | 50.1 | 2.3 | 50.0 | 99.8 |
| Comp. Ex. 1-2 | Comp. AL2 | 50.2 | 2.1 | 50.2 | 100.0 |
| Comp. Ex. 1-3 | Comp. AL3 | 50.1 | 1.3 | 50.0 | 99.8 |

As shown in Table 4, Examples 1-1 to 16 using the inventive compositions AL1 to 16 for forming an adhesive film and Comparative Examples 1-1 to 3 using comparative AL1 to 3 show acceptable levels of film thickness uniformity. A higher molecular weight of the polymer (A) (other than Examples 1-10, 11) resulted in better uniformity than when the molecular weight was lower (Examples 1-10, 11). A lower dispersity (other than Example 1-16 and Comparative Examples 1-1, 2) resulted in better uniformity than when the dispersity was higher (Example 1-16 and Comparative Examples 1-1, 2). These results may be due to the fact that a smaller amount of low molecular weight components in the composition for forming an adhesive film leads to a smaller volatilization amount of these low molecular weight components during film formation by spin-coating and baking.

It can be seen that each of Examples 1-1 to 16 using the inventive compositions AL1 to 16 for forming an adhesive film and Comparative Examples 1-1 to 3 using the comparative compositions for forming an adhesive film produced an adhesive film that has good solvent resistance, with less reduction in film thickness accompanying the solvent treatment.

### Example 2: EUV Exposure Patterning Test with Positive_ Resist (Examples 2-1 to 16 and Comparative Examples 2-1 to 3)

Spin-on carbon ODL-301 (carbon content: 88 mass%), available from Shin-Etsu Chemical Co., Ltd., was applied on a silicon wafer substrate, which was then baked at 350°C for 60 seconds to form a 100-nm resist underlayer film. A silicon-containing spin-on hard mask SHB-A940 (silicon content: 43 mass%), available from Shin-Etsu Chemical Co., Ltd., was applied thereon and baked at 220°C for 60 seconds to form a 15-nm silicon-containing middle layer film. Further, each of the above compositions (AL1 to 16, comparative AL1 to 3) for forming an adhesive film was applied and baked at 220°C for 60 seconds to form a 5-nm (AL1 to 8, 10 to 12, 14 to 16, comparative AL1 to 3) or 15-nm (AL9, 13) adhesive film. A composition for forming a positive resist upper layer film shown in Table 5 was applied thereon and baked at 100°C for 60 seconds to form a 40-nm resist upper layer film.

The composition for forming a positive resist upper layer film (a monolayer resist for EUV) was prepared by dissolving a polymer PRP1 and a quencher Q1 in a solvent containing 0.1 mass% of FC-4430 (available from Sumitomo 3M Limited) in the proportions shown in Table 5 and filtering the resulting solution through a 0.1-pm fluoroplastic filter.

**[Table 5]**

| | Polymer (parts by mass) | Quencher (parts by mass) | Organic solvent (parts by mass) |
|---|---|---|---|
| Composition for forming positive resist upper layer film | PRP1 (100) | Q1 (0.25) | PGMEA/DAA (3,000/1,000) |

| | | | |
|---|---|---|---|
| Polymer for resist: PRP1 Molecular weight (Mw) = 9,200 Dispersity (Mw/Mn) = 1.8 | | | |

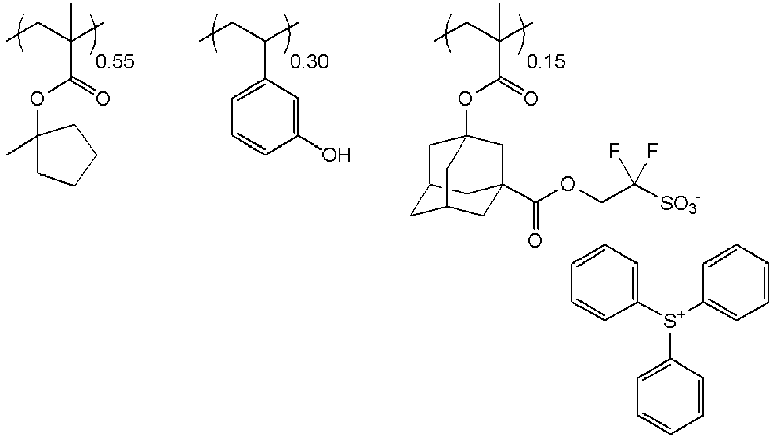

### Quencher: Q1

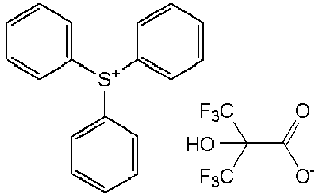

Then, using an EUV exposure apparatus (EUV scanner NXE3400 available from ASML, NA: 0.33, σ: 0.9, 90 degree dipole illumination), the resulting film was exposed to an 18-nm 1:1 line-and-space (LS) pattern, baked (PEB) at 90°C for 60 seconds, and developed for 30 seconds with a 2.38 mass% tetramethylammonium hydroxide (TMAH) aqueous solution, producing a line-and-space pattern with a space width of 18 nm and a pitch of 36 nm. The cross-sectional profile and roughness of this pattern were observed with an electron microscope. A minimum line width that allows for the resolution of the lines without collapse was determined by gradually increasing the exposure dose from that at which the above line-and-space pattern was formed and thereby reducing the line width. The minimum width was defined as the collapse limit (nm), where a smaller value corresponds to higher collapse resistance, which is preferred.

The cross-sectional profile of the obtained pattern was evaluated with an electron microscope (S-4700), available from Hitachi, Ltd., and the pattern roughness was evaluated with an electron microscope (CG6300), available from Hitachi High-Technologies Corp. The results are shown in Table 6.

**[Table 6]**

| Example | Composition for forming adhesive film | Pattern sectional profile after development | Pattern roughness (nm) | Collapse limit (nm) |
|---|---|---|---|---|
| Ex. 2-1 | AL1 | Rectangular | 2.3 | 18 |
| Ex. 2-2 | AL2 | Rectangular | 2.4 | 18 |
| Ex. 2-3 | AL3 | Rectangular | 2.4 | 18 |
| Ex. 2-4 | AL4 | Rectangular | 2.1 | 17 |
| Ex. 2-5 | AL5 | Rectangular | 2,2 | 18 |
| Ex. 2-6 | AL6 | Rectangular | 2.1 | 18 |
| Ex. 2-7 | AL7 | Rectangular | 1.8 | 16 |
| Ex. 2-8 | AL8 | Rectangular | 1.8 | 15 |
| Ex. 2-9 | AL9 | Rectangular | 1.7 | 16 |
| Ex. 2-10 | AL10 | Rectangular | 1.8 | 15 |
| Ex. 2-11 | AL11 | Rectangular | 1.7 | 16 |
| Ex. 2-12 | AL12 | Rectangular | 1.7 | 15 |
| Ex. 2-13 | AL13 | Rectangular | 1.7 | 16 |
| Ex. 2-14 | AL14 | Rectangular | 1.8 | 16 |
| Ex. 2-15 | AL15 | Rectangular | 1.7 | 16 |
| Ex. 2-16 | AL16 | Rectangular | 1.8 | 16 |
| Comp. Ex. 2-1 | Comp. AL1 | Footing | 2.6 | 18 |
| Comp. Ex. 2-2 | Comp. AL2 | Footing | 2.5 | 17 |
| Comp. Ex. 2-3 | Comp. AL3 | Footing | 2.5 | 18 |

As shown in Table 6, Examples 2-1 to 16 using the inventive compositions AL1 to 16 for forming an adhesive film resulted in rectangular patterns and exhibited collapse inhibiting properties. On the other hand, Comparative Examples 2-1 to 3 using comparative AL1 to 3 resulted in footing. In other words, if the polymer (A) for forming an adhesive film contains only one of the repeating units shown by the above general formula (1) or (2), there would be frequent instances of pattern profile defects and greater roughness in top-down view. When both of the repeating units shown in the above general formulas (1) and (2) are introduced, the roughness tends to become better as their content rates become more uniform (Examples 2-1 to 6).

### Example 3: Etching Evaluation (Examples 3-1 to 16, Comparative Examples 3-1 to 3)

Following the formation of the resist upper layer film pattern in Examples 2, the resist upper layer film pattern was used as a mask to dry-etch (transfer the pattern to) a silicon-containing middle layer film using an etching apparatus Telius, available from Tokyo Electron Ltd. The obtained silicon-containing middle layer film pattern was used as a mask to dry-etch (transfer the pattern to) a resist underlayer film and thereby form a resist underlayer film pattern. The etching conditions are as follows.

### (Conditions for transferring the resist upper layer film pattern to the silicon-containing middle layer film)

Chamber pressure: 10.0 Pa
RF power: 1,500 W
CF₄ gas flow rate: 75 mL/min
O₂ gas flow rate: 15 mL/min
Time: 15 sec.

### (Conditions for transferring the silicon-containing middle layer film pattern to the resist underlayer film)

Chamber pressure: 2.0 Pa
RF power: 500 W
Ar gas flow rate: 75 mL/min
O₂ gas flow rate: 45 mL/min
Time: 90 sec.

Whether or not the resist underlayer film pattern could be formed was confirmed by top-down SEM view of the wafer after the pattern transfer to (dry etching of) the resist underlayer film. These evaluation results are shown in Table 7.

**[Table 7]**

| Example | Composition for forming adhesive film | Resist underlayer film pattern |
|---|---|---|
| Ex. 3-1 | AL1 | Formed |
| Ex. 3-2 | AL2 | Formed |
| Ex. 3-3 | AL3 | Formed |
| Ex. 3-4 | AL4 | Formed |
| Ex. 3-5 | AL5 | Formed |
| Ex. 3-6 | AL6 | Formed |
| Ex. 3-7 | AL7 | Formed |
| Ex. 3-8 | AL8 | Formed |
| Ex. 3-9 | AL9 | Formed |
| Ex. 3-10 | AL10 | Formed |
| Ex. 3-11 | AL11 | Formed |
| Ex. 3-12 | AL12 | Formed |
| Ex. 3-13 | AL13 | Formed |
| Ex. 3-14 | AL14 | Formed |
| Ex. 3-15 | AL15 | Formed |
| Ex. 3-16 | AL16 | Formed |
| Comp. Ex. 3-1 | Comp. AL1 | Not Formed |
| Comp. Ex. 3-2 | Comp. AL2 | Not Formed |
| Comp. Ex. 3-3 | Comp. AL3 | Not Formed |

As shown in Table 7, the inventive pattering method (Examples 3-1 to 16) enabled a favorable transfer of the resist upper layer film pattern to the resist underlayer film in both cases where the adhesive film was 5 nm thick (Examples 3-1 to 8, 10 to 12, 14 to 16) and 15 nm thick (Examples 3-9, 13), demonstrating that the adhesive film obtained from the inventive composition for forming an adhesive film is effective for fine patterning by a multilayer resist method.

In contrast, Comparative Examples 3-1 to 3 failed to form a resist underlayer film pattern. These results are due to the occurrence of resist pattern profile defects.

### Example 4: Electron Beam Patterning Test (Examples 4-1 to 16, Comparative Examples 4-1 to 3)

Spin-on carbon ODL-301 (carbon content: 88 mass%), available from Shin-Etsu Chemical Co., Ltd., was applied on a silicon wafer substrate, which was then baked at 350°C for 60 seconds to form a 100-nm resist underlayer film. A silicon-containing spin-on hard mask SHB-A940 (silicon content: 43 mass%), available from Shin-Etsu Chemical Co., Ltd., was applied thereon and baked at 220°C for 60 seconds to form a 20-nm silicon-containing middle layer film. Further, each of the above compositions AL1 to 16 and comparative AL1 to 3 for forming an adhesive film was applied and baked at 220°C for 60 seconds to form a 5-nm adhesive film. A composition for forming a metal-containing resist upper layer film was applied thereon and baked at 180°C for 60 seconds to form a 60-nm resist upper layer film.

The composition for forming a metal-containing resist upper layer film was prepared by dissolving a titanium-containing compound MPRP1 and a metal salt sensitizer S1 in 4-methyl-2-pentanol (MIBC) containing 0.1 mass% of FC-4430 (available from Sumitomo 3M Limited) in the proportions shown in Table 8 and filtering the resulting solution through a 0.1-pm fluoroplastic filter.

**[Table 8]**

| | Titanium-containing compound (parts by mass) | Metal salt sensitizer (parts by mass) | Organic solvent (parts by mass) |
|---|---|---|---|
| Composition for forming metal-containing resist upper layer film | MPRP1 (100) | S1 (1) | MIBC (2,000) |

### Synthesis of Titanium-Containing Compound MPRP1

A solution of 27 g of deionized water in 500 g of 2-propanol (IPA) was added dropwise to a solution of 284 g of titanium tetraisopropoxide (available from Tokyo Chemical Industry Co., Ltd.) in 500 g of IPA, with stirring at room temperature over 2 hours. To the resulting solution was added 180 g of 2,4-dimethyl-2,4-octanediol, followed by stirring at room temperature for 30 minutes. The resulting solution was concentrated under reduced pressure at 30°C and then heated to 60°C. The heating was continued under reduced pressure until distillate stopped coming over. Once distillate was no longer observed, 1,200 g of 4-methyl-2-pentanol (MIBC) was added to the residue, which was heated at 40°C under reduced pressure until there was no IPA to distill. Thus, 1,000 g of a MIBC solution of the titanium-containing compound MPRP1 (concentration of the compound: 25 mass%) was obtained. The polystyrene equivalent molecular weight Mw of the compound was measured to be 1,200.

### Metal salt sensitizer: S1

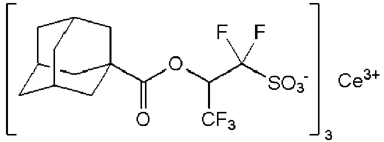

Then, using a system ELS-F125 (available from Elionix Inc.), the resist film was subjected to imagewise exposure at an acceleration voltage of 125 kV in a vacuum chamber. Immediately after the imagewise exposure, the resist film was baked (PEB) at 200°C for 60 seconds and puddle developed in butyl acetate for 20 seconds, producing a negative pattern.

The obtained resist pattern was evaluated as follows. The exposure dose that provided the resolution of a 50-nm 1:1 line-and-space pattern was defined as sensitivity, and a minimum line width that allows for the resolution of the lines without collapse was determined by gradually reducing the exposure dose to thereby reduce the line width. The minimum width was defined as the collapse limit (nm), where a smaller value corresponds to higher collapse resistance, which is preferred. The results are shown in Table 9.

**[Table 9]**

| Example | Composition for forming adhesive film | Collapse limit (nm) |
|---|---|---|
| Ex. 4-1 | AL1 | 48 |
| Ex. 4-2 | AL2 | 49 |
| Ex. 4-3 | AL3 | 49 |
| Ex. 4-4 | AL4 | 47 |
| Ex. 4-5 | AL5 | 46 |
| Ex. 4-6 | AL6 | 47 |
| Ex. 4-7 | AL7 | 44 |
| Ex. 4-8 | AL8 | 44 |
| Ex. 4-9 | AL9 | 43 |
| Ex. 4-10 | AL10 | 45 |
| Ex. 4-11 | AL11 | 45 |
| Ex. 4-12 | AL12 | 43 |
| Ex. 4-13 | AL13 | 43 |
| Ex. 4-14 | AL14 | 44 |
| Ex. 4-15 | AL15 | 45 |
| Ex. 4-16 | AL16 | 45 |
| Comp. Ex. 4-1 | Comp. AL1 | 50 |
| Comp. Ex. 4-2 | Comp. AL2 | 50 |
| Comp. Ex. 4-3 | Comp. AL3 | 50 |

As shown in Table 9, Examples 4-1 to 16 using the inventive compositions AL1 to 16 for forming an adhesive film have smaller collapse limit values than Comparative Examples 4-1 to 3 using comparative AL1 to 3, demonstrating that the present invention provides excellent adhesion to metal-containing resists as well and is effective for fine patterning.

From the above, the adhesive film obtained from the inventive compositions for forming an adhesive film has the effect of inhibiting collapse of fine patterns and is thus extremely useful as an adhesive film employed in multilayer resist methods. Also, the inventive patterning process using such compositions can transfer a fine pattern to a substrate to be processed with high precision.

The present description includes the following embodiments.
[1]: A composition for forming an adhesive film directly under a resist upper layer film, the composition including:
   (A) a polymer containing a repeating unit shown by the following general formula (1) and a repeating unit shown by the following general formula (2); and
   (B) an organic solvent, 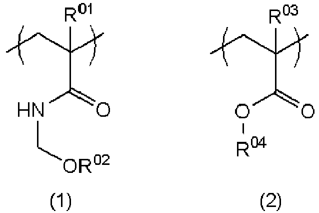 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 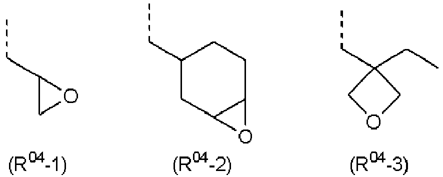 wherein dashed lines denote bonding hands.
[2]: The composition for forming an adhesive film of the above [1], wherein the polymer (A) further contains the following general formula (3), 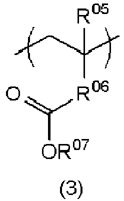 wherein R⁰⁵ is a hydrogen atom or a methyl group, R⁰⁶ is a single bond or a divalent linking group having 2 to 10 carbon atoms and containing an ester group, and R⁰⁷ is a saturated or unsaturated tertiary alkyl group having 4 to 20 carbon atoms.
[3]: The composition for forming an adhesive film of the above [1] or [2], wherein the composition provides an adhesive film with a film thickness of 15 nm or less directly under the resist upper layer film.
[4]: The composition for forming an adhesive film of the above [1], [2], or [3], wherein the polymer (A) has a weight average molecular weight of 6,000 to 50,000.
[5]: The composition for forming an adhesive film of the above [1], [2], [3], or [4], wherein the polymer (A) has a dispersity of 3.0 or less, the dispersity being expressed as weight average molecular weight/number average molecular weight.
[6]: The composition for forming an adhesive film of the above [1], [2], [3], [4], or [5], wherein, in the polymer (A), a content of the repeating unit shown by the general formula (1) is 20 mol% or more and 80 mol% or less relative to whole repeating units, and a content of the repeating unit shown by the general formula (2) is 20 mol% or more and 80 mol% or less relative to the whole repeating units.
[7]: The composition for forming an adhesive film of the above [1], [2], [3], [4], [5], or [6], further including at least one of (C) a thermal acid generator, (D) a photo acid generator, (E) a crosslinking agent, and (F) a surfactant.
[8]: The composition for forming an adhesive film of the above [1], [2], [3], [4], [5], [6], or [7], wherein the resist upper layer film is formed using a composition for forming a resist upper layer film containing at least a metal atom-containing compound and an organic solvent.
[9]: The composition for forming an adhesive film of the above [8], wherein the metal atom-containing compound includes at least one element selected from titanium, cobalt, copper, zinc, zirconium, lead, indium, tin, antimony and hafnium.
[10]: A patterning process for forming a pattern in a substrate to be processed, including the steps of:
   (I-1) applying the composition for forming an adhesive film of the above [1], [2], [3], [4], [5], [6], [7], [8], or [9] on the substrate to be processed and then performing a heat treatment to form an adhesive film;
   (I-2) forming a resist upper layer film on the adhesive film by using a composition for forming a resist upper layer film;
   (I-3) subjecting the resist upper layer film to pattern exposure and then to development with a developer to form a circuit pattern in the resist upper layer film; and
   (I-4) transferring the pattern to the adhesive film and the substrate to be processed by dry etching while using the resist upper layer film having the formed circuit pattern as a mask.
[11]: A patterning process for forming a pattern in a substrate to be processed, including the steps of:
   (II-1) forming a resist underlayer film on the substrate to be processed;
   (II-2) forming a silicon-containing resist middle layer film on the resist underlayer film;
   (II-3) applying the composition for forming an adhesive film of the above [1], [2], [3], [4], [5], [6], [7], [8], or [9] on the silicon-containing resist middle layer film and then performing a heat treatment to form an adhesive film;
   (II-4) forming a resist upper layer film on the adhesive film by using a composition for forming a resist upper layer film;
   (II-5) subjecting the resist upper layer film to pattern exposure and then to development with a developer to form a circuit pattern in the resist upper layer film;
   (II-6) transferring the pattern to the adhesive film and the silicon-containing resist middle layer film by dry etching while using the resist upper layer film having the formed circuit pattern as a mask;
   (II-7) transferring the pattern to the resist underlayer film by dry etching while using the silicon-containing resist middle layer film having the transferred pattern as a mask; and
   (II-8) forming the pattern in the substrate to be processed by processing the substrate to be processed while using the resist underlayer film having the transferred pattern as a mask.
[12]: A patterning process for forming a pattern in a substrate to be processed, including the steps of:
   (III-1) forming a resist underlayer film on the substrate to be processed;
   (III-2) forming an inorganic hard mask middle layer film selected from a silicon oxide film, a silicon nitride film, and a silicon oxynitride film on the resist underlayer film;
   (III-3) applying the composition for forming an adhesive film of the above [1], [2], [3], [4], [5], [6], [7], [8], or [9] on the inorganic hard mask middle layer film and then performing a heat treatment to form an adhesive film;
   (III-4) forming a resist upper layer film on the adhesive film by using a composition for forming a resist upper layer film;
   (III-5) subjecting the resist upper layer film to pattern exposure and then to development with a developer to form a circuit pattern in the resist upper layer film;
   (III-6) transferring the pattern to the adhesive film and the inorganic hard mask middle layer film by dry etching while using the resist upper layer film having the formed circuit pattern as a mask;
   (III-7) transferring the pattern to the resist underlayer film by dry etching while using the inorganic hard mask middle layer film with the transferred pattern as a mask; and
   (III-8) forming the pattern in the substrate to be processed by processing the substrate to be processed while using the resist underlayer film having the transferred pattern as a mask.
[13]: The patterning process of the above [12], wherein the inorganic hard mask middle layer film is formed by a CVD method or an ALD method.
[14]: The patterning process of the above [10], [11], [12], or [13], wherein photolithography at a wavelength of 10 nm or more to 300 nm or less, a direct drawing by electron beam, a nanoimprinting, or a combination thereof is employed as a method for forming the circuit pattern in the resist upper layer film.
[15]: The patterning process of the above [10], [11], [12], [13], or [14], wherein alkaline development or development with an organic solvent is employed as a development method.
[16]: The patterning process of the above [10], [11], [12], [13], [14], or [15], wherein the substrate to be processed is a semiconductor apparatus substrate or the semiconductor apparatus substrate coated with any of a metal film, a metal carbide film, a metal oxide film, a metal nitride film, a metal oxycarbide film, and a metal oxynitride film.
[17]: The patterning process of the above [16], wherein as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used.
[18]: A method for forming an adhesive film employed in a semiconductor apparatus manufacturing process, the method including:
   spin-coating a substrate to be processed with the composition for forming an adhesive film of the above [1], [2], [3], [4], [5], [6], [7], [8], or [9]; and
   heating the substrate coated with the composition for forming an adhesive film at a temperature of 100°C or higher and 300°C or lower for 10 to 600 seconds to form an adhesive film.
[19]: A method for forming an adhesive film employed in a semiconductor apparatus manufacturing process, the method including:
   spin-coating a substrate to be processed with the composition for forming an adhesive film of the above [1], [2], [3], [4], [5], [6], [7], [8], or [9]; and
   heating the substrate coated with the composition for forming an adhesive film in an atmosphere having an oxygen concentration of 0.1% or more and 21% or less to form an adhesive film.
[20]: A method for forming an adhesive film employed in a semiconductor apparatus manufacturing process, the method including:
   spin-coating a substrate to be processed with the composition for forming an adhesive film of the above [1], [2], [3], [4], [5], [6], [7], [8], or [9]; and
   heating the substrate coated with the composition for forming an adhesive film in an atmosphere having an oxygen concentration of less than 0.1% to form an adhesive film.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention. The present invention also refers to the following numbered embodiments, wherein the term "claim" means "embodiment":
1. A composition for forming an adhesive film directly under a resist upper layer film, the composition comprising:
   (A) a polymer containing a repeating unit shown by the following general formula (1) and a repeating unit shown by the following general formula (2); and
   (B) an organic solvent, 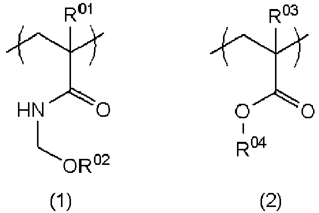 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 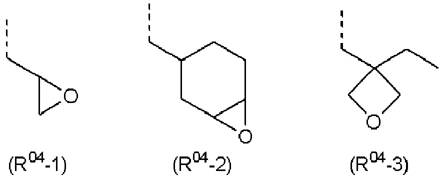 wherein dashed lines denote bonding hands.
2. The composition for forming an adhesive film according to claim 1, wherein the polymer (A) further contains the following general formula (3), 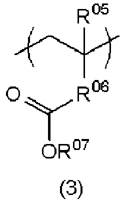 wherein R⁰⁵ is a hydrogen atom or a methyl group, R⁰⁶ is a single bond or a divalent linking group having 2 to 10 carbon atoms and containing an ester group, and R⁰⁷ is a saturated or unsaturated tertiary alkyl group having 4 to 20 carbon atoms.
3. The composition for forming an adhesive film according to claim 1 or 2, wherein the composition provides an adhesive film with a film thickness of 15 nm or less directly under the resist upper layer film.
4. The composition for forming an adhesive film according to any one of claims 1 to 3, wherein the polymer (A) has a weight average molecular weight of 6,000 to 50,000.
5. The composition for forming an adhesive film according to any one of claims 1 to 4, wherein the polymer (A) has a dispersity of 3.0 or less, the dispersity being expressed as weight average molecular weight/number average molecular weight.
6. The composition for forming an adhesive film according to any one of claims 1 to 5, wherein, in the polymer (A), a content of the repeating unit shown by the general formula (1) is 20 mol% or more and 80 mol% or less relative to whole repeating units, and a content of the repeating unit shown by the general formula (2) is 20 mol% or more and 80 mol% or less relative to the whole repeating units.
7. The composition for forming an adhesive film according to any one of claims 1 to 6, further comprising at least one of (C) a thermal acid generator, (D) a photo acid generator, (E) a crosslinking agent, and (F) a surfactant.
8. The composition for forming an adhesive film according to any one of claims 1 to 7, wherein the resist upper layer film is formed using a composition for forming a resist upper layer film containing at least a metal atom-containing compound and an organic solvent.
9. The composition for forming an adhesive film according to claim 8, wherein the metal atom-containing compound includes at least one element selected from titanium, cobalt, copper, zinc, zirconium, lead, indium, tin, antimony and hafnium.
10. A patterning process for forming a pattern in a substrate to be processed, comprising the steps of:
   (I-1) applying the composition for forming an adhesive film according to any one of claims 1 to 9 on the substrate to be processed and then performing a heat treatment to form an adhesive film;
   (I-2) forming a resist upper layer film on the adhesive film by using a composition for forming a resist upper layer film;
   (I-3) subjecting the resist upper layer film to pattern exposure and then to development with a developer to form a circuit pattern in the resist upper layer film; and
   (I-4) transferring the pattern to the adhesive film and the substrate to be processed by dry etching while using the resist upper layer film having the formed circuit pattern as a mask.
11. A patterning process for forming a pattern in a substrate to be processed, comprising the steps of:
   (II-1) forming a resist underlayer film on the substrate to be processed;
   (II-2) forming a silicon-containing resist middle layer film on the resist underlayer film;
   (II-3) applying the composition for forming an adhesive film according to any one of claims 1 to 9 on the silicon-containing resist middle layer film and then performing a heat treatment to form an adhesive film;
   (II-4) forming a resist upper layer film on the adhesive film by using a composition for forming a resist upper layer film;
   (II-5) subjecting the resist upper layer film to pattern exposure and then to development with a developer to form a circuit pattern in the resist upper layer film;
   (II-6) transferring the pattern to the adhesive film and the silicon-containing resist middle layer film by dry etching while using the resist upper layer film having the formed circuit pattern as a mask;
   (II-7) transferring the pattern to the resist underlayer film by dry etching while using the silicon-containing resist middle layer film having the transferred pattern as a mask; and
   (II-8) forming the pattern in the substrate to be processed by processing the substrate to be processed while using the resist underlayer film having the transferred pattern as a mask.
12. A patterning process for forming a pattern in a substrate to be processed, comprising the steps of:
   (III-1) forming a resist underlayer film on the substrate to be processed;
   (III-2) forming an inorganic hard mask middle layer film selected from a silicon oxide film, a silicon nitride film, and a silicon oxynitride film on the resist underlayer film;
   (III-3) applying the composition for forming an adhesive film according to any one of claims 1 to 9 on the inorganic hard mask middle layer film and then performing a heat treatment to form an adhesive film;
   (III-4) forming a resist upper layer film on the adhesive film by using a composition for forming a resist upper layer film;
   (III-5) subjecting the resist upper layer film to pattern exposure and then to development with a developer to form a circuit pattern in the resist upper layer film;
   (III-6) transferring the pattern to the adhesive film and the inorganic hard mask middle layer film by dry etching while using the resist upper layer film having the formed circuit pattern as a mask;
   (III-7) transferring the pattern to the resist underlayer film by dry etching while using the inorganic hard mask middle layer film with the transferred pattern as a mask; and
   (III-8) forming the pattern in the substrate to be processed by processing the substrate to be processed while using the resist underlayer film having the transferred pattern as a mask.
13. The patterning process according to claim 12, wherein the inorganic hard mask middle layer film is formed by a CVD method or an ALD method.
14. The patterning process according to any one of claims 10 to 13, wherein photolithography at a wavelength of 10 nm or more to 300 nm or less, a direct drawing by electron beam, a nanoimprinting, or a combination thereof is employed as a method for forming the circuit pattern in the resist upper layer film.
15. The patterning process according to any one of claims 10 to 14, wherein alkaline development or development with an organic solvent is employed as a development method.
16. The patterning process according to any one of claims 10 to 15, wherein the substrate to be processed is a semiconductor apparatus substrate or the semiconductor apparatus substrate coated with any of a metal film, a metal carbide film, a metal oxide film, a metal nitride film, a metal oxycarbide film, and a metal oxynitride film.
17. The patterning process according to claim 16, wherein as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used.
18. A method for forming an adhesive film employed in a semiconductor apparatus manufacturing process, the method comprising:
   spin-coating a substrate to be processed with the composition for forming an adhesive film according to any one of claims 1 to 9; and
   heating the substrate coated with the composition for forming an adhesive film at a temperature of 100°C or higher and 300°C or lower for 10 to 600 seconds to form an adhesive film.
19. A method for forming an adhesive film employed in a semiconductor apparatus manufacturing process, the method comprising:
   spin-coating a substrate to be processed with the composition for forming an adhesive film according to any one of claims 1 to 9; and
   heating the substrate coated with the composition for forming an adhesive film in an atmosphere having an oxygen concentration of 0.1% or more and 21% or less to form an adhesive film.
20. A method for forming an adhesive film employed in a semiconductor apparatus manufacturing process, the method comprising:
   spin-coating a substrate to be processed with the composition for forming an adhesive film according to any one of claims 1 to 9; and
   heating the substrate coated with the composition for forming an adhesive film in an atmosphere having an oxygen concentration of less than 0.1% to form an adhesive film.

## Claims

1. A composition for forming an adhesive film directly under a resist upper layer film, the composition comprising:
(A) a polymer containing a repeating unit shown by the following general formula (1) and a repeating unit shown by the following general formula (2); and
(B) an organic solvent, 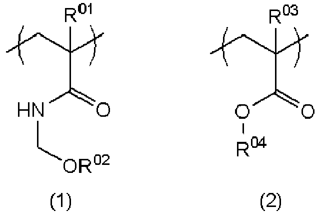 wherein R⁰¹ and R⁰³ are each independently a hydrogen atom or a methyl group, R⁰² is a linear or branched alkyl group having 1 to 10 carbon atoms, where a hydrogen atom contained in R⁰² is optionally substituted with a hydroxyl group, and R⁰⁴ is an organic group selected from the following formulae (R⁰⁴-1) to (R⁰⁴-3), 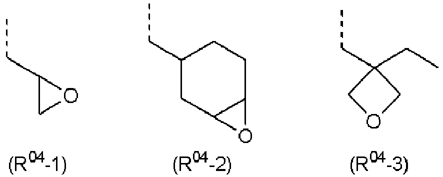 wherein dashed lines denote bonding hands.

2. The composition for forming an adhesive film according to claim 1, wherein the polymer (A) further contains the following general formula (3), 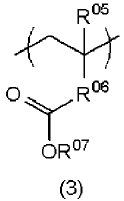 wherein R⁰⁵ is a hydrogen atom or a methyl group, R⁰⁶ is a single bond or a divalent linking group having 2 to 10 carbon atoms and containing an ester group, and R⁰⁷ is a saturated or unsaturated tertiary alkyl group having 4 to 20 carbon atoms.

3. The composition for forming an adhesive film according to claim 1 or 2, wherein the composition provides an adhesive film with a film thickness of 15 nm or less directly under the resist upper layer film.

4. The composition for forming an adhesive film according to any one of claims 1 to 3, wherein the polymer (A) has a weight average molecular weight of 6,000 to 50,000.

5. The composition for forming an adhesive film according to any one of claims 1 to 4, wherein the polymer (A) has a dispersity of 3.0 or less, the dispersity being expressed as weight average molecular weight/number average molecular weight.

6. The composition for forming an adhesive film according to any one of claims 1 to 5, wherein, in the polymer (A), a content of the repeating unit shown by the general formula (1) is 20 mol% or more and 80 mol% or less relative to whole repeating units, and a content of the repeating unit shown by the general formula (2) is 20 mol% or more and 80 mol% or less relative to the whole repeating units.

7. The composition for forming an adhesive film according to any one of claims 1 to 6, further comprising at least one of (C) a thermal acid generator, (D) a photo acid generator, (E) a crosslinking agent, and (F) a surfactant.

8. The composition for forming an adhesive film according to any one of claims 1 to 7, wherein the resist upper layer film is formed using a composition for forming a resist upper layer film containing at least a metal atom-containing compound and an organic solvent.

9. The composition for forming an adhesive film according to claim 8, wherein the metal atom-containing compound includes at least one element selected from titanium, cobalt, copper, zinc, zirconium, lead, indium, tin, antimony and hafnium.

10. A patterning process for forming a pattern in a substrate to be processed, comprising the steps of:
a)
(I-1) applying the composition for forming an adhesive film according to any one of claims 1 to 9 on the substrate to be processed and then performing a heat treatment to form an adhesive film;
(I-2) forming a resist upper layer film on the adhesive film by using a composition for forming a resist upper layer film;
(I-3) subjecting the resist upper layer film to pattern exposure and then to development with a developer to form a circuit pattern in the resist upper layer film; and
(I-4) transferring the pattern to the adhesive film and the substrate to be processed by dry etching while using the resist upper layer film having the formed circuit pattern as a mask; or
b)
(II-1) forming a resist underlayer film on the substrate to be processed;
(II-2) forming a silicon-containing resist middle layer film on the resist underlayer film;
(II-3) applying the composition for forming an adhesive film according to any one of claims 1 to 9 on the silicon-containing resist middle layer film and then performing a heat treatment to form an adhesive film;
(II-4) forming a resist upper layer film on the adhesive film by using a composition for forming a resist upper layer film;
(II-5) subjecting the resist upper layer film to pattern exposure and then to development with a developer to form a circuit pattern in the resist upper layer film;
(II-6) transferring the pattern to the adhesive film and the silicon-containing resist middle layer film by dry etching while using the resist upper layer film having the formed circuit pattern as a mask;
(II-7) transferring the pattern to the resist underlayer film by dry etching while using the silicon-containing resist middle layer film having the transferred pattern as a mask; and
(II-8) forming the pattern in the substrate to be processed by processing the substrate to be processed while using the resist underlayer film having the transferred pattern as a mask;
or
c)
(III-1) forming a resist underlayer film on the substrate to be processed;
(III-2) forming an inorganic hard mask middle layer film selected from a silicon oxide film, a silicon nitride film, and a silicon oxynitride film on the resist underlayer film;
(III-3) applying the composition for forming an adhesive film according to any one of claims 1 to 9 on the inorganic hard mask middle layer film and then performing a heat treatment to form an adhesive film;
(III-4) forming a resist upper layer film on the adhesive film by using a composition for forming a resist upper layer film;
(III-5) subjecting the resist upper layer film to pattern exposure and then to development with a developer to form a circuit pattern in the resist upper layer film;
(III-6) transferring the pattern to the adhesive film and the inorganic hard mask middle layer film by dry etching while using the resist upper layer film having the formed circuit pattern as a mask;
(III-7) transferring the pattern to the resist underlayer film by dry etching while using the inorganic hard mask middle layer film with the transferred pattern as a mask; and
(III-8) forming the pattern in the substrate to be processed by processing the substrate to be processed while using the resist underlayer film having the transferred pattern as a mask.

11. The patterning process according to claim 10c, wherein the inorganic hard mask middle layer film is formed by a CVD method or an ALD method.

12. The patterning process according to claim 10 or 11, wherein photolithography at a wavelength of 10 nm or more to 300 nm or less, a direct drawing by electron beam, a nanoimprinting, or a combination thereof is employed as a method for forming the circuit pattern in the resist upper layer film.

13. The patterning process according to any one of claims 10 to 12, wherein alkaline development or development with an organic solvent is employed as a development method.

14. The patterning process according to any one of claims 10 to 13, wherein the substrate to be processed is a semiconductor apparatus substrate or the semiconductor apparatus substrate coated with any of a metal film, a metal carbide film, a metal oxide film, a metal nitride film, a metal oxycarbide film, and a metal oxynitride film;
preferably
wherein as the metal, silicon, titanium, tungsten, hafnium, zirconium, chromium, germanium, copper, silver, gold, aluminum, indium, gallium, arsenic, palladium, iron, tantalum, iridium, cobalt, manganese, molybdenum, or an alloy thereof is used.

15. A method for forming an adhesive film employed in a semiconductor apparatus manufacturing process, the method comprising:
a)
spin-coating a substrate to be processed with the composition for forming an adhesive film according to any one of claims 1 to 9; and
heating the substrate coated with the composition for forming an adhesive film at a temperature of 100°C or higher and 300°C or lower for 10 to 600 seconds to form an adhesive film;
or
b)
spin-coating a substrate to be processed with the composition for forming an adhesive film according to any one of claims 1 to 9; and
heating the substrate coated with the composition for forming an adhesive film in an atmosphere having an oxygen concentration of 0.1% or more and 21% or less to form an adhesive film;
or
c)
spin-coating a substrate to be processed with the composition for forming an adhesive film according to any one of claims 1 to 9; and
heating the substrate coated with the composition for forming an adhesive film in an atmosphere having an oxygen concentration of less than 0.1% to form an adhesive film.
